(19)

Europäisches Patentamt
European Patent Office
Office européen des brevets

(11) **EP 3 425 901 A1**

(12) **EUROPEAN PATENT APPLICATION**
published in accordance with Art. 153(4) EPC

(43) Date of publication:
   **09.01.2019 Bulletin 2019/02**

(21) Application number: **17759712.7**

(22) Date of filing: **20.02.2017**

(51) Int Cl.:
   **H04N 5/372** (2011.01)   **G01B 11/24** (2006.01)
   **G01C 3/06** (2006.01)   **G01S 17/89** (2006.01)
   **H01L 27/148** (2006.01)   **H04N 5/33** (2006.01)

(86) International application number:
   **PCT/JP2017/006106**

(87) International publication number:
   **WO 2017/150246 (08.09.2017 Gazette 2017/36)**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**
   Designated Validation States:
   **MA MD**

(30) Priority: **29.02.2016   JP 2016038439**

(71) Applicant: **Panasonic Intellectual Property
   Management Co., Ltd.
   Osaka-shi, Osaka 540-6207 (JP)**

(72) Inventors:
   • **OTANI Mitsuhiko**
     **Osaka 540-6207 (JP)**
   • **TAKANO Haruka**
     **Osaka 540-6207 (JP)**

(74) Representative: **Vigand, Philippe et al
   Novagraaf International SA
   Chemin de l'Echo 3
   1213 Onex - Genève (CH)**

(54) **IMAGING DEVICE AND SOLID-STATE IMAGING ELEMENT USED IN SAME**

(57)   An imaging device (10) includes: a controller (3) which generates a light emission signal and an exposure signal; a light source unit (1) which emits light in response to the light emission signal; an imager (2) which obtains an amount of exposure to reflected light at the timing according to the exposure signal; and a signal processor (4) which outputs a distance image and a luminance image according to calculation based on a signal amount of an imaging signal received from the imager (2). The imager (2) is configured so that a pixel which performs exposure for obtaining signals of the distance image and a pixel which performs exposure for obtaining signals of the luminance image are the same. The light source unit (1) emits light according to the timing indicated by the light emission signal generated at the controller (3), also in a period in which the imager (2) performs the exposure for obtaining signals of the luminance image.

FIG. 1

**Description**

TECHNICAL FIELD

The present invention relates to an imaging device and a solid-state imaging element used in the imaging device.

BACKGROUND ART

Methods for three-dimensionally detecting an object are known in which both a distance image and a luminance image are used in calculation and signal processing.
Patent Literature (PTL) 1 discloses a conventional technique for improving three-dimensional detection accuracy by using, in calculation and signal processing, both a distance image obtained by a distance image sensor and a luminance image obtained by a normal image sensor.

Citation List

Patent Literature

PTL 1: Japanese Unexamined Patent Application Publication No. 2015-194838

SUMMARY OF THE INVENTION

TECHNICAL PROBLEM

In the conventional technique disclosed in PTL 1, however, two cameras including different solid-state imaging elements are used to obtain the distance image and the luminance image, and thus a distance measurement error occurs due to a mismatch between a viewpoint for the distance image and a viewpoint for the luminance image. Particularly, when a subject (target object) is close, a problem arises in that the distance measurement error is noticeable.
In view of the aforementioned problem, an object of the present invention is to provide a miniaturized imaging device which is capable of three-dimensional detection, measurement, display, or rendering with high detection accuracy or high measurement accuracy that does not depend on the environment illuminance.

SOLUTION TO PROBLEM

In order to solve the aforementioned problem, an imaging device according to an aspect of the present invention includes: a controller which generates a light emission signal and an exposure signal, the light emission signal instructing emission of irradiation light, the exposure signal instructing exposure to reflected light from an object; a light source unit configured to emit the irradiation light according to the light emission signal; an imager including a solid-state imaging element which includes a plurality of pixels, performs exposure a plurality of times according to the exposure signal, performs image capture in which signals are accumulated in different ones of a plurality of signal accumulators among the plurality of pixels, and outputs an imaging signal corresponding to the image capture; and a signal processor which outputs a distance image and a luminance image according to calculation based on a signal amount of the imaging signal. The imaging signal includes a distance imaging signal for obtaining the distance image by calculation and a luminance imaging signal for obtaining the luminance image by calculation. The solid-state imaging element generates the distance imaging signal and the luminance imaging signal from the same one of the plurality of pixels. In a period in which the solid-state imaging element performs the exposure to obtain the luminance imaging signal, the light source unit emits the irradiation light according to a timing indicated by the light emission signal, as in a period in which the solid-state imaging element performs the exposure to obtain the distance imaging signal.

ADVANTAGEOUS EFFECT OF INVENTION

The imaging device according to the present invention obtains an accurate distance image and a high quality luminance image from a solid-state imaging element, and thus, while being small in size, is capable of three-dimensional detection, measurement, display, or rendering with high detection accuracy or high measurement accuracy that does not depend on the environment illuminance by using the distance image and the luminance image in calculation.

BRIEF DESCRIPTION OF DRAWINGS

FIG. 1 is a function block diagram illustrating an outline configuration of an imaging device according to Embodiment 1.

FIG. 2A illustrates a configuration of a charge coupled device (CCD) solid-state imaging element.

FIG. 2B illustrates one example of the pixel arrangement of a solid-state imaging element according to Embodiment 1.

FIG. 2C illustrates that a distance imaging signal and a luminance imaging signal are generated from the same pixel in a solid-state imaging element according to Embodiment 1.

FIG. 2D illustrates one example of the pixel arrangement of a solid-state imaging element according to Embodiment 1.

FIG. 2E illustrates an example of the pixel arrangement of a solid-state imaging element according to Embodiment 1.

FIG. 3 is a timing chart illustrating an outline of an operation of an imaging device according to Embodiment 1.

FIG. 4 is a timing chart in the first light emission/exposure period that is chronologically the first and the second light emission/exposure period that is chronologically the first for a distance image frame.

FIG. 5 is a timing chart in the third light emission/exposure period that is chronologically the first and the second light emission/exposure period that is chronologically the second for a distance image frame.

FIG. 6 illustrates an example of the timing for detecting an exposure amount for a distance image frame in an imaging device according to Embodiment 1.

FIG. 7 is a timing chart in a luminance exposure period, a luminance background light exposure period, and a luminance transfer period for a luminance image frame.

FIG. 8 is a timing chart illustrating an outline of an operation of an imaging device according to Variation 1 of Embodiment 1.

FIG. 9 is a timing chart in the third light emission/exposure period that is chronologically the first and the first light emission/exposure period that is chronologically the second for a distance image frame.

FIG. 10 illustrates an example of the timing for detecting an exposure amount in an imaging device according to Variation 1 of Embodiment 1.

FIG. 11 illustrates an example of the timing for detecting an exposure amount in an imaging device according to Variation 1 of Embodiment 1.

FIG. 12 illustrates an example of the timing for detecting an exposure amount in an imaging device according to Variation 2 of Embodiment 1.

FIG. 13 illustrates a change in the exposure amount in an imaging device according to Variation 2 of Embodiment 1 with respect to the distance to a subject.

FIG. 14 illustrates the relationship between the actual distance and the measured distance value of an imaging device according to Variation 2 of Embodiment 1.

FIG. 15 illustrates an example of the timing for detecting an exposure amount in an imaging device according to Variation 3 of Embodiment 1.

FIG. 16 illustrates the relationship between an exposure amount and the relative phase between a light emission signal and an exposure signal in an imaging device according to Variation 3 of Embodiment 1.

FIG. 17 is a timing chart illustrating an outline of an operation of an imaging device according to Variation 4 of Embodiment 1.

FIG. 18 is a timing chart illustrating an outline of an operation of an imaging device according to Variation 5 of Embodiment 1.

FIG. 19 is a timing chart illustrating an outline of an operation of an imaging device according to Variation 6 of Embodiment 1.

FIG. 20 is a timing chart illustrating an outline of an operation of an imaging device according to Variation 7 of Embodiment 1.

FIG. 21 is a timing chart illustrating an outline of an operation of an imaging device according to Embodiment 2.

FIG. 22 is a timing chart illustrating an outline of an operation of an imaging device according to Embodiment 2.

FIG. 23 illustrates the timing for detecting an exposure amount in an imaging device according to Embodiment 2.

FIG. 24 illustrates an example of a configuration of a complementary metal oxide semiconductor (CMOS) image sensor.

DESCRIPTION OF EXEMPLARY EMBODIMENTS

Hereinafter, an imaging device and a solid-state imaging element used in the imaging device according to embodiments of the present disclosure will be described with reference to the drawings. Note that each of the following embodiments shows one specific example of the present invention; the numerical values, shapes, materials, structural elements, the arrangement and connection of the structural elements, etc., shown in the following embodiments are mere examples, and are not intended to limit the present invention.

There are instances where overly detailed description is omitted. For example, detailed description of well-known matter, redundant description of substantially identical structural elements, etc., may be omitted. This is to prevent the subsequent description from becoming unnecessarily redundant, and thus facilitate understanding by a person having ordinary skill in the art.

EMBODIMENT 1

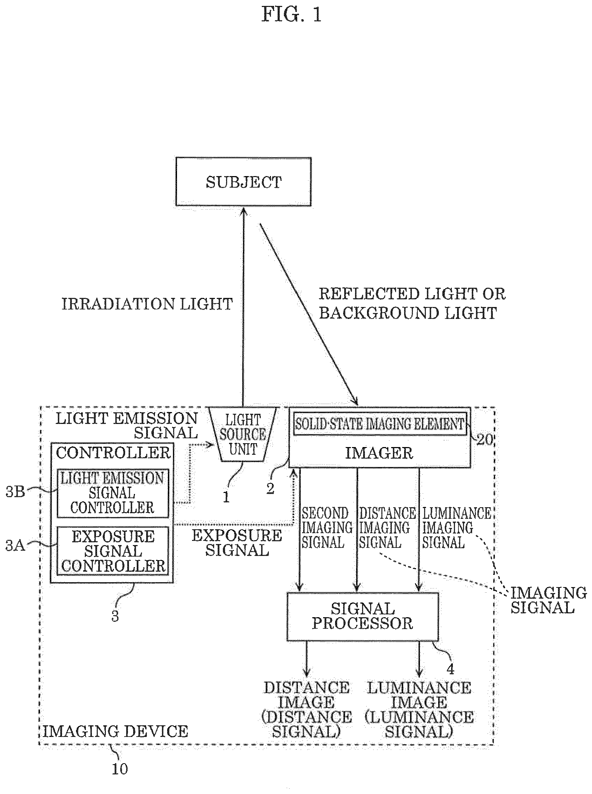

FIG. 1 is a function block diagram illustrating an example of an outline configuration of imaging device (distance measurement imaging device) 10 according to Embodiment 1. As illustrated in this figure, imaging device 10 includes light source unit 1, imager 2, controller (drive controller) 3, and signal processor 4. With this configuration, imaging device 10 is capable of capturing not only still images, but also moving images.

Light source unit 11 includes a drive circuit, a capacitor, and a light-emitting element, and emits irradiation light by supplying a charge held in the capacitor to a light-emitting diode. The light-emitting element may be a laser diode, a light-emitting diode (LED), or the like. The irradiation light is, as an example, infrared light (including near-infrared light and far-infrared light).

Controller 3 includes at least exposure signal controller 3A and light emission signal controller 3B, and generates, by light emission signal controller 3B, a light emission signal instructing light emission to a subject (object, measurement object), and generates, by exposure signal controller 3A, an exposure signal instructing exposure to reflected light from the subject and background light to be described later. Note that although light emission signal controller 3B and exposure signal controller 3A are included in controller 3 in FIG. 1, light emission signal controller 3B and exposure signal controller 3A may be configured as separate controllers.

Furthermore, in such a case, light emission signal controller 3B may be included in light source unit 1, and exposure signal controller 3A may be included in imager 2.

Light source unit 1 blinks (emits pulsed light) according to the timing of the light emission signal generated by controller 3 and emits irradiation light (pulsed light) to the subject.

Imager 2 includes solid-state imaging element 20. Solid-state imaging element 20 receives reflected light (pulsed light) resulting from reflection of the irradiation light. Furthermore, when light source unit 1 does not perform light-emitting operations, solid-state imaging element 20 receives background light (ambient light) such as sunlight or background light (ambient light) that is an offset component such as a dark current component.

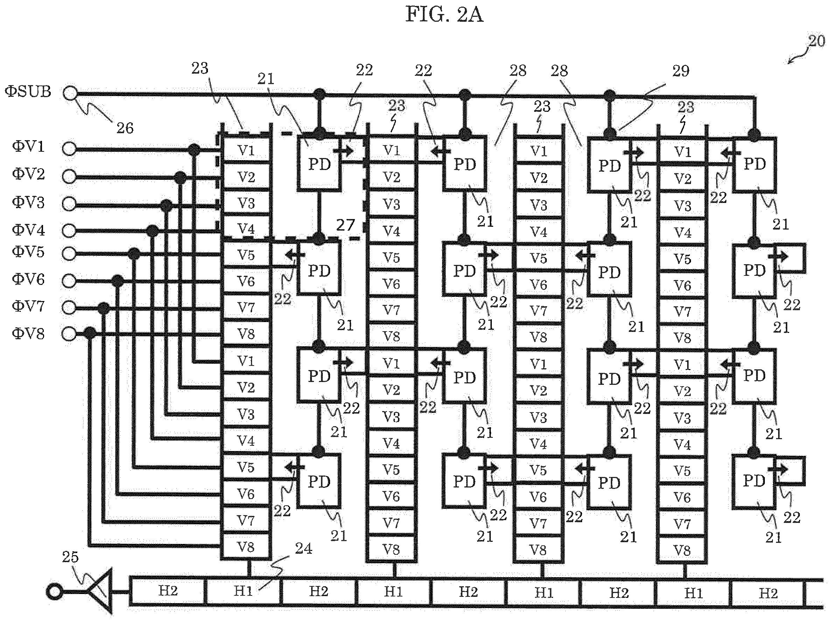

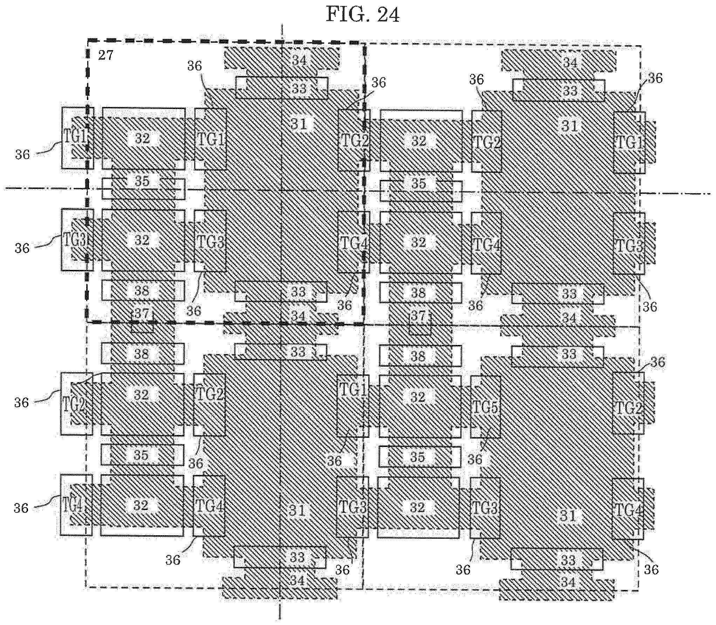

Furthermore, solid-state imaging element 20 performs, for an area including the subject, exposure a plurality of times according to the timing indicated by the exposure signal generated by controller 3, performs image capture in which signals are accumulated in different ones of a plurality of signal accumulators (vertical transfer portion 23 in FIG. 2A and charge accumulator 32 in FIG. 24) among pixels, and then transfers the accumulated signals to obtain an imaging signal and a second imaging signal which correspond to the exposure amounts. The imaging signal includes a distance imaging signal and a luminance imaging signal for respectively generating a distance image and a luminance image to be described later, through exposure to the reflected light from the subject based on the irradiation light. The second imaging signal is obtained through exposure to the background light such as sunlight or the background light that is an offset component such as a dark current component in the state where light source unit 1 does not emit the irradiation light.

Imager 2 further includes: a camera lens; an optical band-pass filter (BPF) which passes only light having a wavelength close to the wavelength of light emitted from light source unit 1; and a circuit such as an A/D converter, as appropriate.

Signal processor 4 outputs a distance image (a distance signal or signal information) and a luminance image (a luminance signal or luminance information) according to calculation based on the signal amounts of the imaging signal and the second imaging signal received from imager 2. In parallel with this, three-dimensional object detection (detection) or object measurement (measurement) are performed by calculation using the distance image and the luminance image.

The following describes the case where a charge coupled device (CCD) solid-state imaging element (image sensor) is used as an example of imager 2 in imaging device 10 according to the present embodiment.

FIG. 2A illustrates a configuration of CCD solid-state imaging element 20. FIG. 2A is a configuration diagram illustrating an example of solid-state imaging element 20 according to the present embodiment; imager 2 includes this solid-state imaging element 20. Herein, only the part encompassing four pixels in the vertical direction and four pixels in the horizontal direction is illustrated to facilitate understanding of the present invention.

As illustrated in FIG. 2A, solid-state imaging element 20 according to the present embodiment includes: a plurality of light-receiving regions (light receivers or photoelectric converters; for example, photodiodes or PDs) 21; a plurality of readout gates (readers) 22; a plurality of vertical transfer portions (first transfer portions) 23; horizontal transfer portion (second transfer portion) 24; output amplifier 25; and SUB terminal 26 to which signal $\varphi$SUB for controlling semiconductor substrate voltage (SUB) is input.

Vertical transfer portion 23 and horizontal transfer portion 24 serve as charge accumulators (signal accumulators) through which charges (signals or signal charges) are transferred and in which charges (signals or signal charges) are accumulated.

Note that although the pixel includes at least light-receiving region 21 and is defined as a repeating unit (unit cell or unit pixel) in FIG. 2A, the case where the pixel is defined as light-receiving region 21 itself is also included.

The plurality of light-receiving regions 21 are arranged in rows and columns on a semiconductor substrate, and each convert incident light into a signal charge.

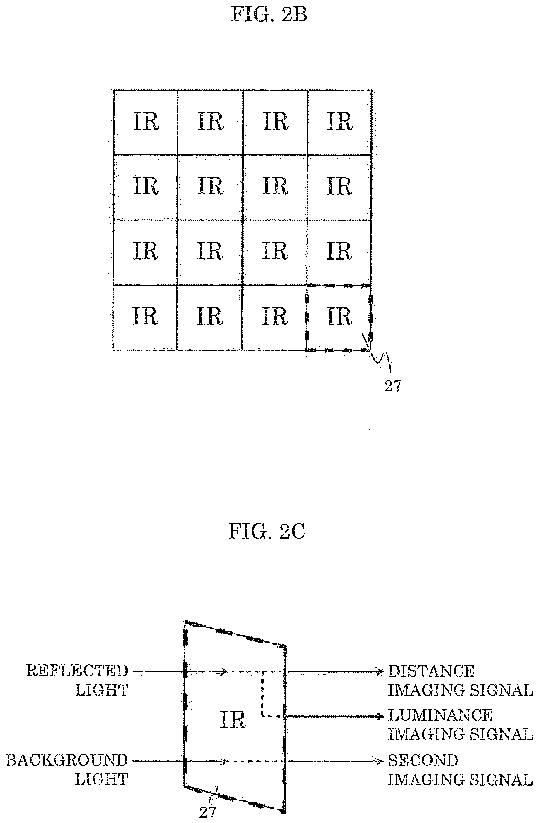

FIG. 2B illustrates one example of the pixel arrangement of solid-state imaging element 20 according to Embodiment 1. As illustrated in FIG. 2B, each pixel 27 of solid-state imaging element 20 is an image sensor that has a sensitivity to irradiation light (as an example, infrared rays IR (including near infrared rays and far infrared rays) and background light.

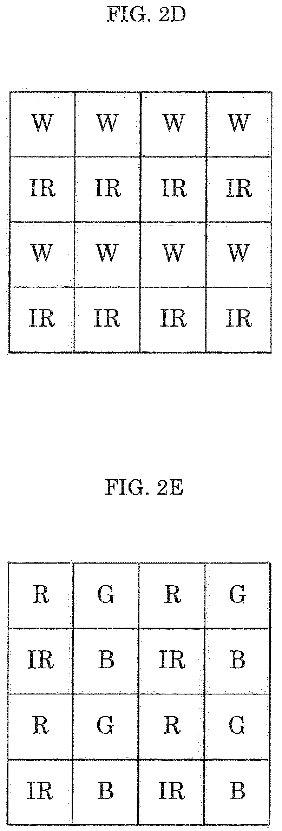

Note that solid-state imaging element 20 according to Embodiment 1 is not limited to having the pixel arrangement illustrated in FIG. 2B and may have a pixel arrangement in which other pixels (as an example, a white (W) pixel which receives visible light or a red (R) pixel, a green (G) pixel, and a blue (B) pixel which receives light in a specific wavelength range of visible light) are included, as illustrated in FIG. 2D and FIG. 2E.

FIG. 2C illustrates that a distance imaging signal and a luminance imaging signal are generated from the same pixel in solid-state imaging element 20 according to Embodiment 1. As illustrated in FIG. 2C, the pixel structure of solid-state imaging element 20 is characterized in that a pixel (or a light-receiving region) which generates the luminance imaging signal, a pixel (or a light-receiving region) which generates the distance imaging signal, a pixel (or a light-receiving region) which generates the second imaging signal are not different from each other, but the imaging signal (the luminance imaging signal and the distance imaging pixel) and the second imaging signal are generated from the same pixel (shared pixel) 27.

Specifically, in imaging device 10 (and solid-state imaging element 20) according to the present embodiment, a signal for obtaining the distance image (the distance imaging signal and the second imaging signal) and a signal for obtaining the luminance image (the luminance imaging signal and the second imaging signal) are obtained at the same pixel 27 of solid-state imaging element 20. Accordingly, the viewpoint for the distance image and the viewpoint for the luminance image are matched, and thus it is possible to obtain high distance measurement accuracy. Furthermore, it is possible to obtain a high resolution (high definition) distance image having a resolution of one out of several parts of pixel 27 included in solid-state imaging element 20.

Furthermore, the aperture ratio (the area ratio at which light can be received per unit area) of pixel 27 which generates the imaging signal can be increases; it is possible to generate an accurate imaging signal with less noise, and solid-state imaging element 20 and imaging device 10 can be downsized.

Furthermore, as illustrated in FIG. 2A, the plurality of readout gates 22 are provided corresponding to light-receiving regions 21 and read out signal charges from corresponding light-receiving regions 21.

The plurality of vertical transfer portions 23 include a plurality of gates and sequentially transfer, in the vertical direction, the signal charges read out by readout gates 22 from light-receiving regions 21. Each of the plurality of vertical transfer portions 23 includes, for example, 8-phase electrodes V1 to V8 (hereinafter also referred to as gates V1 to V8) through which the signal charges read out from the light-receiving region 21 are transferred in the column direction (vertical direction).

Horizontal transfer portion 24 includes a plurality of gates and sequentially transfers, in the horizontal direction (the row direction), the signal charges transferred from the plurality of vertical transfer portions 23. This horizontal transfer portion 24 includes, for example, 2-phase electrodes H1 and H2.

Output amplifier 25 sequentially detects the signal charges transferred from horizontal transfer portion 24, converts the signal charges into voltage signals, and outputs the voltage signals.

Here, among gates V1 to V8 included in vertical transfer portions 23 described above, gates V1 and V5 are used along with readout gates 22 provided corresponding to respective light-receiving regions 21, so as to enable per-row and per-column reading. Furthermore, channel stop 28 for impeding entry of the signal charge is provided on the opposite side of light-receiving region 21 from where readout gate 22 is formed.

Vertical over flow drain (VOFD) 29 is formed in the bulk direction (the depth direction of the semiconductor substrate) of each light-receiving region 21; when a high voltage is applied to SUB terminal 26, the signal charges in all light-receiving regions 21 are collectively discharged to the outside via vertical over flow drain 29. Specifically, when SUB terminal 26 is at the high level, the signal charges in light-receiving regions 21 are discharged to the semiconductor substrate (the outside), and when SUB terminal 26 is at the low level, the signal charges photoelectrically converted in light-receiving regions 21 are accumulated.

Furthermore, when SUB terminal 26 is set to the low level in the state where $\varphi V1$ and $\varphi V5$ representing pulses applied respectively to gate V1 and gate V5 included in vertical transfer portion 23 are at the high level and readout gates 22 are open, the signal charges photoelectrically converted inside light-receiving regions 21 are accumulated in a packet under gate V1 and a packet under gate V5.

In other words, the exposure signal output from controller 3 and instructing an exposure timing is signal ($\varphi$SUB

which is input to SUB terminal 26 and used to control the semiconductor substrate voltage (SUB).

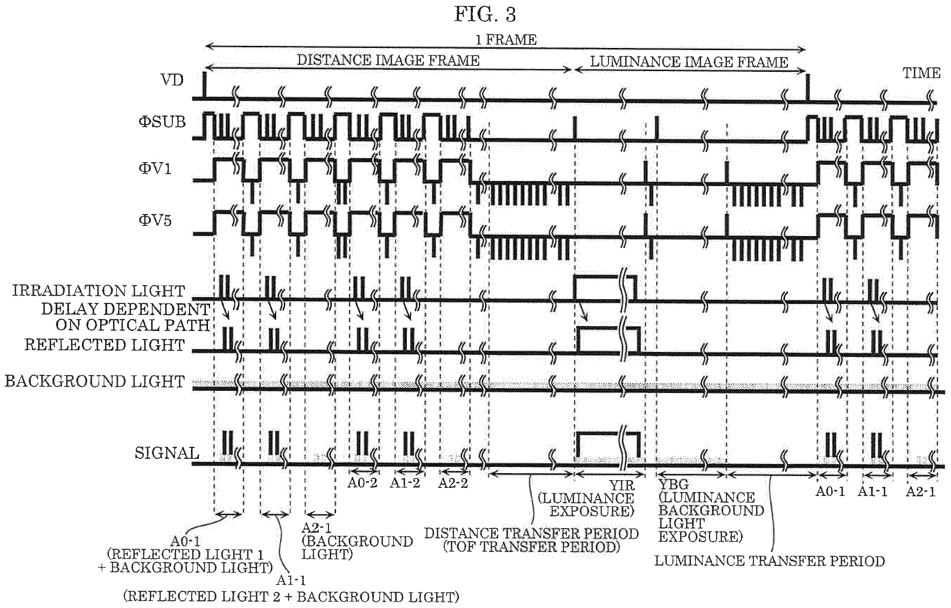

Next, a method for driving imaging device 10 (operation timing) according to the present embodiment will be described with reference to FIG. 3 to FIG. 7. Note that as described later with reference to FIG. 3 to FIG. 7, imaging device 10 according to the present embodiment uses the TOF method as a method for obtaining a distance image, and adopts, as a basic principle, the rectangular-wave TOF method (pulse TOF method) in which repetition of light emission and exposure includes a phase in which no exposure is performed.

FIG. 3 is a timing chart illustrating an outline of an operation of imaging device 10 according to Embodiment 1. Specifically, FIG. 3 illustrates an example of the drive timing in which the signal charges generated in two horizontally adjacent light-receiving regions 21 are read out to vertical transfer portion 23 and transferred in the vertical direction within one frame period. FIG. 3 illustrates: vertical synchronization pulse VD; φSUB which is an exposure signal; φV1 and φV5 among gates V1 to V8 included in vertical transfer portion 23 that are used along with readout gates 22; irradiation light (infrared light) emitted from light source unit 1; reflected light that is light reflected by the subject; background light; and SIGNAL indicating an image of the signal charge generated in light-receiving region 21.

Vertical synchronization pulse VD has more than one frame per second, and each frame period includes a distance image frame and a luminance image frame.

The distance image frame period includes a first light emission/exposure period (A0 period), a second light emission/exposure period (A1 period), a third light emission/exposure period (A2 period), and distance transfer period (TOF transfer period) in order to obtain the distance imaging signal (imaging signal).

The first light emission/exposure period (A0 period) and the second light emission/exposure period (A1 period) are periods in which the timing in light-receiving region 21 for exposure to reflected light (reflected light 1 and reflected light 2) delayed according to the distance to the subject is different with respect to the timing for emitting light (irradiation light) from light source unit 1. More specifically, the first light emission/exposure period (A0 period) and the second light emission/exposure period (A1 period) are periods in which the timing phase of exposure signal φSUB from controller 3 instructing exposure to reflected light (reflected light 1 and reflected light 2) delayed in light-receiving region 21 of solid-state imaging element 20 according to the distance to the subject is different with respect to the timing for emitting light (irradiation light) from light source unit 1 according to the light emission signal generated at controller 3.

The third light emission/exposure period (A2 period) is a period in which the light emission from light source unit 1 is stopped, light-receiving region 21 is exposed only to the background light according to the timing of exposure signal (φSUB from controller 3, and the second imaging signal is obtained.

The distance transfer period (TOF transfer period) is a period in which three types of signals accumulated by the exposure in the first, second, and third light emission/exposure periods are transferred and the distance imaging signals (imaging signals) are output to signal processor 4.

Meanwhile, the luminance image frame includes a luminance exposure period (YIR period), a luminance background light exposure period (YBG period), and a luminance transfer period in order to obtain the luminance imaging signal (imaging signal).

The luminance exposure period (YIR period) is a period in which light (irradiation light) is emitted from light source unit 1 according to the light emission signal generated at controller 3 and light-receiving region 21 is exposed to the reflected light from the subject.

The luminance background light exposure period exposure period (YBG period) is a period in which the light emission from light source unit 1 is stopped, light-receiving region 21 is exposed only to the background light, and the second imaging signal is obtained.

The luminance transfer period is a period in which two types of signals accumulated by the exposure in the luminance exposure period and the luminance background light exposure period are transferred and the luminance imaging signal (imaging signal) is output to signal processor 4.

In other words, imaging device 10 according to the present embodiment is characterized in that as in the case of generating the distance imaging signal, the luminance imaging signal is not generated using the background light only, but is generated based on the irradiation light emitted from light source unit 1 according to the light emission signal generated at controller 3 also in the case of generating the luminance imaging signal.

In other words, light source unit 1 is characterized in that the irradiation light is emitted according to the timing indicated by the light emission signal, also during a period in which solid-state imaging element 20 performs exposure in order to obtain the luminance imaging signal, as in the case of the luminance imaging signal.

Thus, imaging device 10 according to the present embodiment emits light (irradiation light) from light source unit 1 also during the exposure period for obtaining signals of the luminance image, and therefore can obtain a high quality luminance image without depending on the environment illuminance.

Furthermore, as the signal accumulator and the driving method for accumulating or transferring signals in the exposure period, it is possible to make a selection with a priority on the distance measurement accuracy for signals for obtaining the distance image while making a selection with a priority on the image quality for signals for obtaining the luminance image.

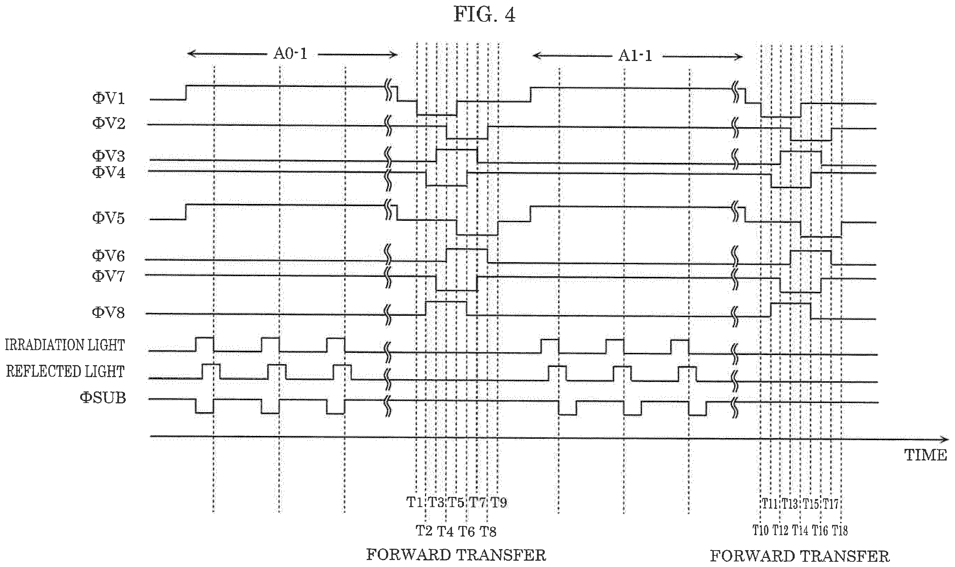

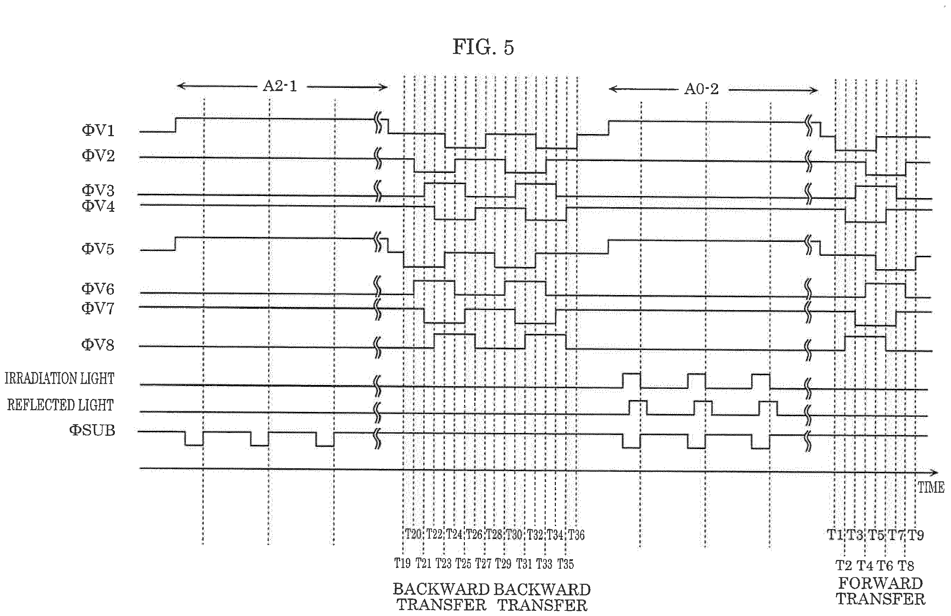

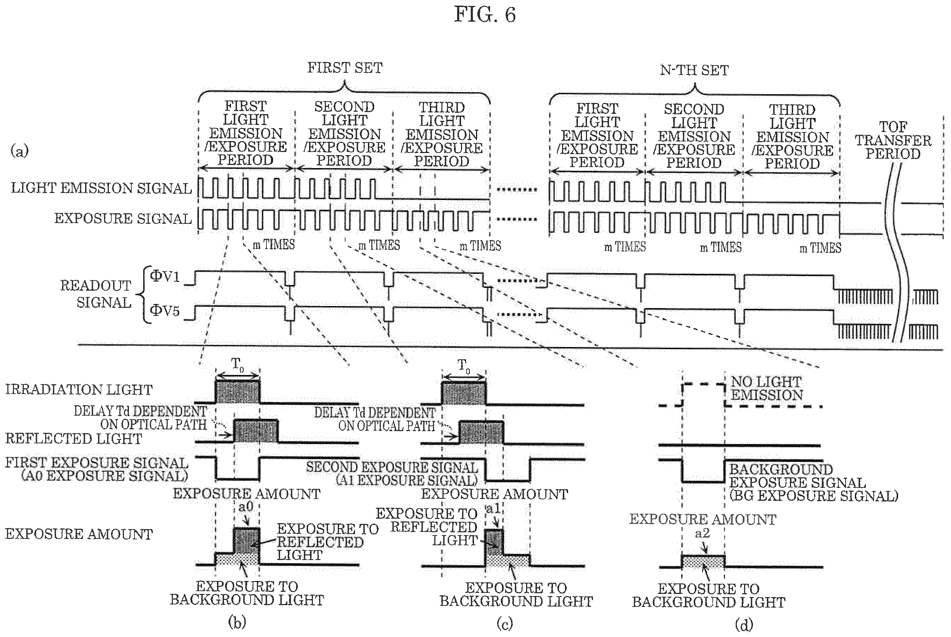

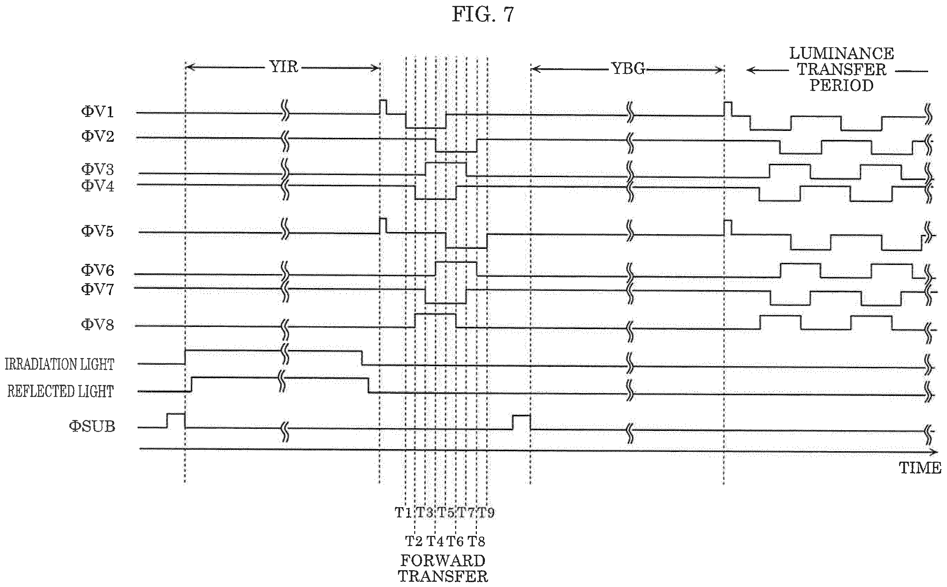

FIG. 4 is a timing chart in the first light emission/exposure period that is chronologically the first and the second light emission/exposure period that is chronologically the first for a distance image frame. FIG. 5 is a timing chart in the third light emission/exposure period that is chronologically the first and the first light emission/exposure period that is chronologically the second for a distance image frame. FIG. 7 is a timing chart in the luminance exposure period, the luminance background light exposure period, and the luminance transfer period for a luminance image frame. FIG. 6 illustrates an example of the timing for detecting an exposure amount for a distance image frame in imaging device 10 according to Embodiment 1.

FIG. 6 illustrates, in (a), the timing relationship in one distance image frame between a light emission signal (irradiation light), an exposure signal ($\varphi$SUB), and readout signals ($\varphi$V1 and $\varphi$V5), which controller 3 outputs. FIG. 6 illustrates, in (b), the timing for detecting exposure amount a0 in the first light emission/exposure period (A0 period). FIG. 6 illustrates, in (c), the timing for detecting exposure amount a1 in the second light emission/exposure period (A1 period). FIG. 6 illustrates, in (d), the timing for detecting exposure amount a2 in the third light emission/exposure period (A2 period).

As illustrated in FIG. 3 and FIG. 4 described earlier, in the first light emission/exposure period (A0-1 period) for the distance image frame, in the state where $\varphi$V1 and $\varphi$V5 are set to the high level and readout gates 22 are open, light-receiving region 21 receives exposure signal $\varphi$SUB from controller 3 after a first delay time and performs exposure in the low level period with respect to the timing at which light source unit 1 emits light in response to the light emission signal from controller 3.

In the present embodiment, as illustrated in FIG. 6, the length of the first exposure signal period ($\varphi$SUB is at the low level) is set to $T_0$, which is the same as the length of the light emission signal period, with the first delay time of 0, that is, the period in which the light emission signal is transmitted (at the high level).

In the present embodiment, as illustrated in FIG. 6, these first light emission and exposure are repeated m times, and charges generated by the exposure are accumulated in the packets under gates V1 and V5 which are readout gates 22 of vertical transfer portion 23. Thereafter, $\varphi$V1 and $\varphi$V5 are set to the middle level and readout gates 22 are closed, and pulses $\varphi$V1 to $\varphi$V8 indicated at time T1 to time T9 in FIG. 4 are applied, causing the signal charges accumulated in vertical transfer portion 23 in the A0-1 period to be transferred forward through vertical transfer portion 23 to the packet under a gate at which readout gate 22 is not present; thus, the signal charges under gates V1 and V5 drain.

Subsequently, as illustrated in FIG. 3 and FIG. 4, in the second light emission/exposure period (A1-1 period) for the distance image frame, in the state where $\varphi$V1 and $\varphi$V5 are set to the high level and readout gates 22 are open, light-receiving region 21 receives exposure signal $\varphi$SUB from controller 3 after a second delay time different from the first delay time and performs exposure in the low level period with respect to the timing at which light source unit 1 emits light in response to the light emission signal from controller 3.

In the present embodiment, as illustrated in FIG. 6, the length of the second exposure signal period ($\varphi$SUB is at the low level) is set to To, which is the same as the length of the light emission signal period and the length of the first exposure signal period, and the second delay time is set to To, which is the sum of the first delay time 0 and the first exposure signal period.

In the present embodiment, as illustrated in FIG. 6, these second light emission and exposure are repeated m times, and charges generated by the exposure are accumulated in the packets under gates V1 and V5 which are readout gates 22 of vertical transfer portion 23. Thereafter, $\varphi$V1 and $\varphi$V5 are set to the middle level and readout gates 22 are closed, and pulses $\varphi$V1 to $\varphi$V8 indicated at time T10 to time T18 in FIG. 4 are applied, causing the signal charges accumulated in vertical transfer portion 23 in the AO-1 period and the A1-1 period to be transferred forward through vertical transfer portion 23 to the packet under a gate at which readout gate 22 is not present; thus, the signal charges under gates V1 and V5 drain again.

Subsequently, as illustrated in FIG. 3 and FIG. 5, in the third light emission/exposure period (A2-1 period) for the distance image frame, in the state where $\varphi$V1 and $\varphi$V5 are set to the high level and readout gates 22 are open, the light emission from light source unit 1 is stopped, and light-receiving region 21 receives exposure signal $\varphi$SUB from controller 3 and performs exposure in the low level period. In the present embodiment, the length of the exposure signal ($\varphi$SUB is at the low level) period in this period is set to To, which is the same as the lengths of the first exposure signal period and the second exposure signal period.

In the present embodiment, as illustrated in FIG. 6, these third light emission and exposure are repeated m times, and charges generated by the exposure are accumulated in the packets under gates V1 and V5 which are readout gates 22 of vertical transfer portion 23. Thereafter, $\varphi$V1 and $\varphi$V5 are set to the middle level and readout gates 22 are closed, and pulses $\varphi$V1 to $\varphi$V8 indicated at time T19 to time T36 in FIG. 5 are applied. This causes the signal charges accumulated in vertical transfer portion 23 in the AO-1 period, the A1-1 period, and the A2-1 period to be transferred backward through vertical transfer portion 23; thus, the signal charges accumulated in the A0-1 period reach the packet at which readout gate 22 is present.

At this time, the three types of signal charges, i.e., the signal charges accumulated in the A0-1 period, the signal charges accumulated in the A1-1 period, and the signal charges accumulated in the A2-1 period are not mixed up and are independently stored in the packets in vertical transfer portion 23.

Next, as illustrated in FIG. 3 and FIG. 5, the operation in the first light emission/exposure period (A0-1 period) that is chronologically the first is repeated again as the first light emission/exposure period (A0-2 period) that is chronologically the second. This means that the signal charges in the A0-1 period and the signal charges in the A0-2 period are added up and stored in vertical transfer portion 23. Next, pulses φV1 and φV8 indicated at time T1 to time T9 in FIG. 5 are applied, causing the signal charges accumulated in vertical transfer portion 23 in the A0-1 period and the A0-2 period, the A1-1 period, and the A2-1 period to be transferred forward through vertical transfer portion 23; thus, the signal charges accumulated in the A1-1 period reach the packet under a gate at which readout gate 22 is present.

In the subsequent operation, as illustrated in FIG. 3, when the operation is repeated, in the second light emission/exposure period (A1-2 period) that is chronologically the second, exposure is performed in substantially the same operation as that in the abovementioned second light emission/exposure period (A1-1 period) that is chronologically the first, causing the signal charges accumulated in the A1-1 period and the signal charges accumulated in the A1-2 period to be added up inside vertical transfer portion 23. In the third light emission/exposure period (A2-2 period) that is chronologically the second, exposure is performed in substantially the same operation as that in the abovementioned third light emission/exposure period (A2-1 period) that is chronologically the first, causing the signal charges accumulated in the A2-1 period and the signal charges accumulated in the A2-2 period to be added up inside vertical transfer portion 23.

Thereafter, as shown in FIG. 6, this series of operations is repeatedly performed N times, then the transfer in vertical transfer portion 23 and the transfer in horizontal transfer portion 24 are repeatedly performed sequentially in the distance transfer period, and output amplifier 25 converts the charges into a voltage signal and outputs the voltage signal to signal processor 4 as an imaging signal.

The distance measuring operation for a distance image frame by imaging device 10 according to the present embodiment will be described below in detail with reference to FIG. 6.

FIG. 6 illustrates, in (a), the timing relationship in one screen between the light emission signal, the irradiation light, the first to third exposure signals (φSUB), and the readout signals (φV1 and φV5). In the present embodiment, the number of repetitions of the light emission signal and the exposure signal in each of the first to third light emission/exposure periods is m, with this series of timings being regarded as one set. This set is repeatedly output N times, and then the accumulated exposure signals are output. Here, let A0 be the total sum of exposure amounts a0 according to the first exposure signal, A1 be the total sum of exposure amounts a1 according to the second exposure signal, and A2 be the total sum of exposure amounts a2 according to the third exposure signal. Here, in the present embodiment, since the light emission from light source unit 1 is stopped in the third light emission/exposure period, A2 represents the background light only. Thus, signal processor 4 can calculate distance L to the subject by calculating, for each pixel, the following Expression 1 where c is the speed of light (299,792,458 m/s).

[Math. 1]

$$L = \frac{c \times T_0}{2} \times \frac{A1 - A2}{A0 - A2 + A1 - A2} \qquad (\text{Expression 1})$$

In this way, the exposure is controlled in the distance image frame period using only signal φSUB for controlling the substrate voltage (SUB) in the state where φV1 and φV5 are at the high level and readout gates 22 are open.

Thus, all light-receiving regions 21 are subject to accurate, high-speed exposure control at the same time, and A0, A1, and A2 in Expression 1 stated above have increased accuracy; consequently, it is possible to obtain signals for obtaining an accurate distance image.

Subsequently, as illustrated in FIG. 3 and FIG. 7, in the luminance exposure period (YIR period) for the luminance image frame, in the state where φV1 and φV5 are set to the middle level and readout gates 22 are closed, exposure signal φSUB from controller 3 is set to the high level first, and then all the charges accumulated in light-receiving regions 21 are discharged to the semiconductor substrate (the outside) before exposure signal φSUB returns to the low level.

Next, light source unit 1 emits light continuously for a predetermined time according to the light emission signal generated at controller 3, light-receiving regions 21 are exposed to the reflected light from the subject, charges are accumulated, and after a lapse of a predetermined time since the end of the light emission from light source unit 1, φV1 and φV5 are set to the high level and readout gates 22 are opened. This causes the charges accumulated in light-receiving regions 21 to be read out to the packets under gates V1 and V5 which are readout gates 22 of vertical transfer portion 23. When the readout is complete, φV1 and φV5 are set to the middle level and readout gates 22 are closed, and pulses φV1 to φV8 indicated at time T1 to T9 in FIG. 7 are applied. This causes the signal charges accumulated in vertical transfer portion 23 in the YIR period to be transferred forward through vertical transfer portion 23 to the packet under a gate at which readout gate 22 is not present; thus, the signal charges under gates V1 and V5 drain.

The length of time from the end of the light emission from light source unit 1 until φV1 and φV5 are set to the high level may be set in consideration of the delay dependent on the optical path of reflected light from the most distant subject among subjects the images of which are desired to be captured. Here, the exposure period starts from a point at which exposure signal φSUB from controller 3 changes from the high level to the low level, and ends at a point at which φV1 and φV5 are set to the high level and readout gates 22 are opened.

Therefore, the signal charges accumulated through this exposure are attributed to the reflected light from the subject and the background light in the exposure period, resulting in an image indicated by SIGNAL in FIG. 3.

Subsequently, as illustrated in FIG. 3 and FIG. 7, in the luminance background light exposure period (YBG period) for the luminance image frame, in the state where φV1 and φV5 are set to the middle level and readout gates 22 are closed, exposure signal φSUB from controller 3 is set to the high level first, and then all the charges accumulated in light-receiving regions 21 are discharged to the semiconductor substrate (the outside) before exposure signal φSUB returns to the low level.

Next, the light emission from light source unit 1 is stopped, light-receiving regions 21 are exposed, charges are accumulated, and after a lapse of a predetermined time, φV1 and φV5 are set to the high level and readout gates 22 are opened. This causes the charges accumulated in light-receiving regions 21 to be read out to the packets under gates V1 and V5 which are readout gates 22 of vertical transfer portion 23. When the readout is complete, φV1 and φV5 are set to the middle level and readout gates 22 are closed.

At this time, the two types of signals, i.e., the signal charges accumulated in the YIR period and the signal charges accumulated in the YBG period, are not mixed up and are independently stored in the packets in vertical transfer portion 23.

Here, the exposure period in the luminance background light exposure period (YBG period) starts from a point at which exposure signal φSUB from controller 3 changes from the high level to the low level, and ends at a point at which φV1 and φV5 are set to the high level and readout gates 22 are opened.

In the present embodiment, the exposure period in the luminance background light exposure period (YBG period) is set to have the same length as the exposure period in the luminance exposure period (YIR period). Therefore, the signal charges accumulated through this exposure are attributed to the background light in the exposure period, and the exposure amount is the same as that of the background light included in the signals obtained through the exposure in the luminance exposure period (YIR period), resulting in an image indicated by SIGNAL in FIG. 3.

Thereafter, the transfer in vertical transfer portion 23 and the transfer in horizontal transfer portion 24 are repeatedly performed sequentially in the luminance transfer period, and output amplifier 25 converts the charges into a voltage signal and outputs the voltage signal to signal processor 4 as an imaging signal. Signal processor 4 subtracts, in the calculation for obtaining a luminance image, the signals obtained through the exposure in the luminance background light exposure period (YBG period) from the signals obtained through the exposure in the luminance exposure period (YIR period).

As described above, in the luminance image frame, readout gates 22 are open only when the charges are read out from light-receiving regions 21 to vertical transfer portion 23, and thus it is possible to obtain a high-quality luminance image in which the amount of noise attributable to time during which readout gates 22 are open is small.

Furthermore, in the calculation for obtaining a luminance image through light emission from light source unit 1 in the luminance exposure period, the signals obtained through the exposure in the luminance background light exposure period (YBG period) is subtracted from the signals obtained through the exposure in the luminance exposure period (YIR period), and thus a luminance image including only luminance information of the light emitted from light source unit 1 and reflected from the subject can be obtained, leading to a further reduction in the dependency of image quality on the background light. In addition, it is possible to obtain a specific luminance image defined by absorption, fluorescence, and reflectivity of the subject with respect to the wavelength of light (irradiation light) emitted from light source unit 1; thus, specific three-dimensional detection, measurement, or the like can be performed with high accuracy.

For example, the use of infrared light enables accurate three-dimensional measurement and accurate, high-quality stereoscopic display, rendering, etc., of the form of a subject which is difficult to detect with visible light, for example, blood vessels.

Furthermore, a plurality of packets already included in vertical transfer portion 23 can be used as a means for accumulating per-pixel signals obtained in a plurality of exposure periods that differ in the timing of exposure signals at which the reflected light from the subject is received with respect to the light emission signals in the distance image frame and as a means for accumulating, for each pixel in the luminance image frame, signals obtained when the light source emits light and signals obtained when the light source does not emit light. Accordingly, it is no longer necessary to additionally form a signal accumulation means, and larger light-receiving regions 21 can be formed over the same area, allowing an increase in the saturation sensitivity. This increases the maximum light reception amount, resulting in an accurate distance image and a high quality luminance image.

As described above, with imaging device 10 according to the present embodiment, three-dimensional detection and measurement are performed by calculation using accurate distance image and luminance image obtained from the same pixel 27 of solid-state imaging element 20. Specifically, the distance information based on the distance image and the luminance information based on the luminance image which are obtained from the same pixel of the solid-state imaging element are used in the calculation, and thus, for example, stereoscopic detection, display, and rendering of the form of a subject, such as a point cloud, are made possible with high accuracy and high image quality, and accurate three-dimensional detection, measurement, or the like including accurate eye gaze detection, accurate gesture recognition, accurate obstacle detection, and accurate road surface detection can be performed.

Furthermore, imaging device 10 according to the present embodiment can use, as a plurality of signal accumulators which accumulate different signals for respective pixels 27, the plurality of packets already included in the vertical transfer portion. Accordingly, it is no longer necessary to additionally form a signal accumulation means, and larger light-receiving regions (photodiodes) 21 can be formed over the same area, allowing an increase in the saturation sensitivity. This increases the maximum light reception amount, resulting in an accurate distance image and a high quality luminance image.

Furthermore, with imaging device 10 and solid-state imaging element 20 according to the present embodiment, the signal charges in all light-receiving regions 21 are collectively discharged to the outside via vertical over flow drain 29. In other words, an operation of collectively resetting the plurality of light-receiving regions 21 (photodiodes), what is called global reset, can be performed; when a distance image and a luminance image having matching viewpoints without image distortion are obtained, high distance measurement and subject detection accuracy can be obtained.

VARIATION 1 OF EMBODIMENT 1

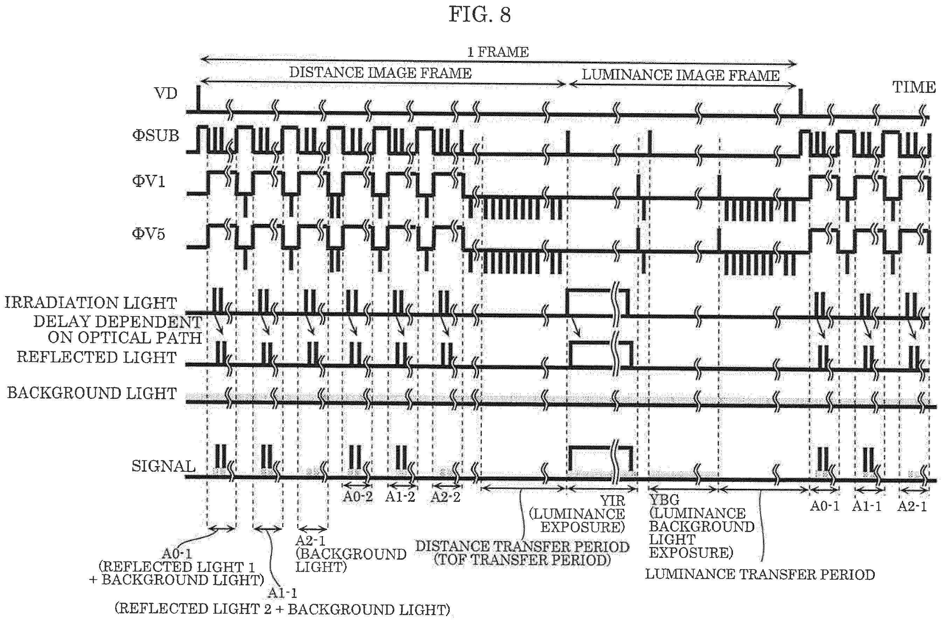

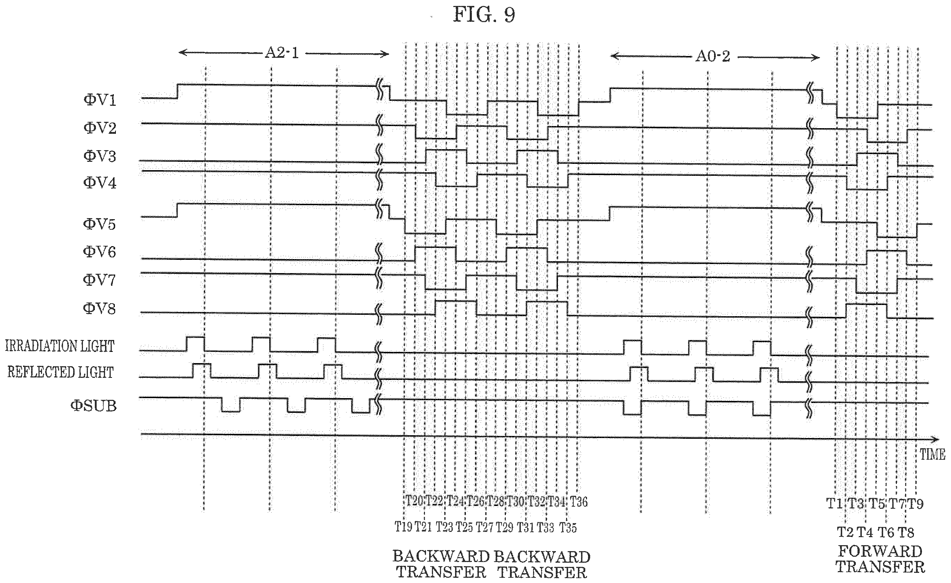

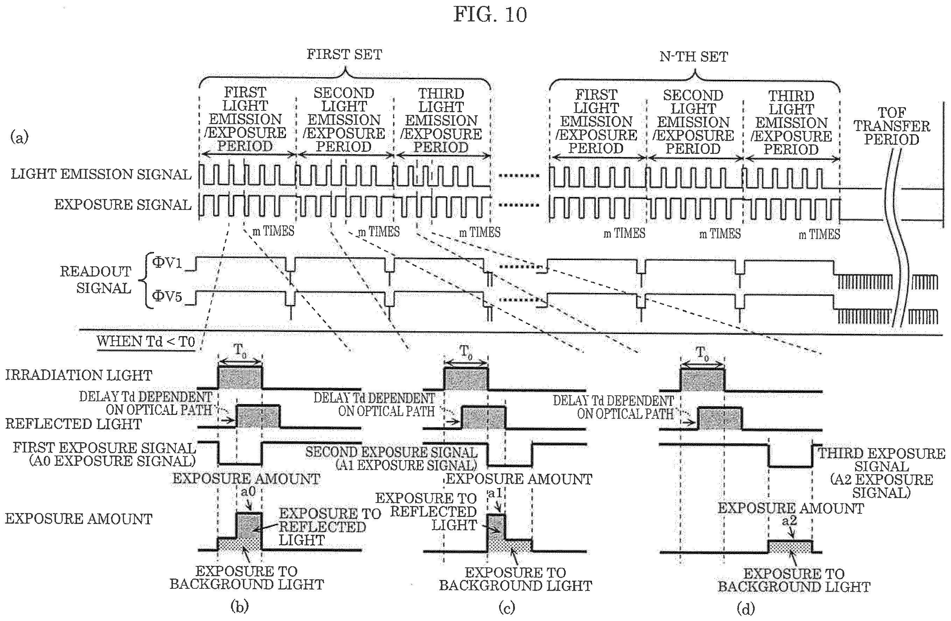

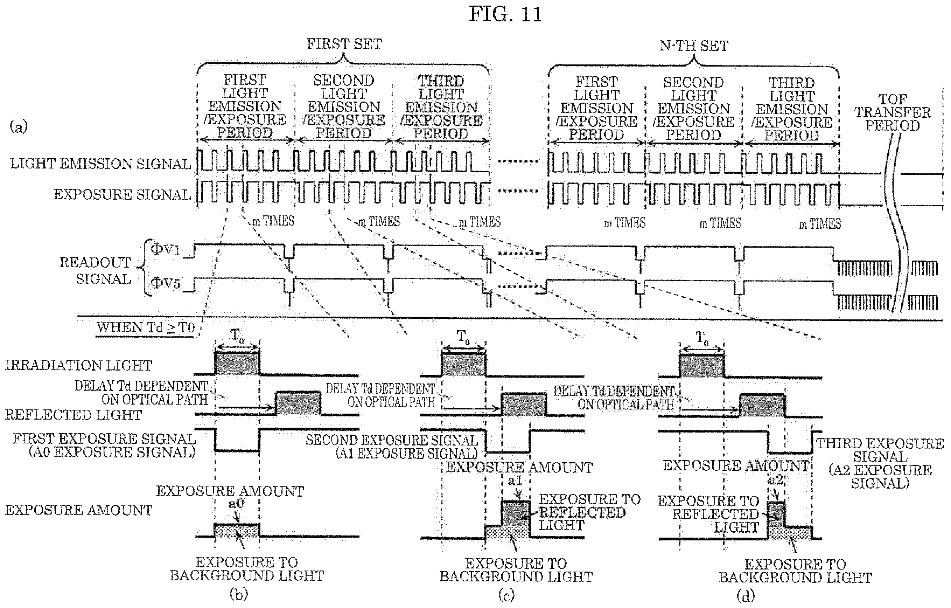

FIG. 8 is a timing chart illustrating an outline of an operation of imaging device 10 according to Variation 1 of Embodiment 1. FIG. 9 is a timing chart in the third light emission/exposure period (A2-1 period) that is chronologically the first and the first light emission/exposure period (A0-2 period) that is chronologically the second for a distance image frame. FIG. 10 and FIG. 11 each illustrate an example of the timing for detecting an exposure amount for a distance image frame in imaging device 10 according to Variation 1 of Embodiment 1.

Each of (a) in FIG. 10 and in (a) in FIG. 11 illustrates the timing relationship in one distance image frame between the readout signals ($\varphi$V1 and $\varphi$V5) and the light emission signals (irradiation light) and the exposure signals ($\varphi$SUB) which controller 3 outputs. Each of (b) in FIG. 10 and (b) in FIG. 11 illustrates the timing for detecting exposure amount a0 in the first light emission/exposure period (A0 period). Each of (c) in FIG. 10 and (c) in FIG. 11 illustrates the timing for detecting exposure amount a1 in the second light emission/exposure period (A1 period). Each of (d) in FIG. 10 and (d) in FIG. 11 illustrates the timing for detecting exposure amount a2 in the third light emission/exposure period (A2 period).

This is different from Embodiment 1 in that in the third exposure/light emission period (A2) for the distance image frame, the light emission from light source unit 1 is not stopped, and in the state where $\varphi$V1 and $\varphi$V5 are set to the high level and readout gates 22 are open, light-receiving region 21 receives exposure signal $\varphi$SUB from controller 3 after a third delay time different from the first delay time and the second delay time and performs exposure in the low level period with respect to the timing at which light source unit 1 emits light in response to the light emission signal from controller 3.

In the present embodiment, as illustrated in FIG. 10 and FIG. 11, the length of the third exposure signal ($\varphi$SUB is at the low level) period is set to To, which is the same as the length of the light emission signal period and the lengths of the first and second exposure signal periods, and the third delay time is set to $2 \times T_0$, which is the sum of the first delay time 0, the first exposure signal period $T_0$, and the second exposure period $T_0$.

Thus, when delay Td dependent on the optical path of light (reflected light 1, reflected light 2) reflected from the subject with respect to the light emission signal timing (irradiation light) is less than value $T_0$, which is the sum of first exposure signal period $T_0$ and the delay time 0 of first exposure signal $\varphi$SUB with respect to the timing at which light source unit 1 emits light in response to the light emission signal, exposure to the background light alone is performed in the third exposure signal period, as illustrated in FIG. 10.

In contrast, when delay Td dependent on the optical path of light (reflected light 1, reflected light 2) reflected from the subject with respect to the light emission signal timing (irradiation light) is greater than or equal to value $T_0$, which is the sum of first exposure signal period $T_0$ and the delay time 0 of first exposure signal $\varphi$SUB with respect to the timing at which light source unit 1 emits light in response to the light emission signal, exposure to the background light alone is performed in the first exposure signal period, as illustrated in FIG. 11.

Let A0 be the total sum of exposure amounts a0 according to the first exposure signal, A1 be the total sum of exposure amounts a1 according to the second exposure signal, and A2 be the total sum of exposure amounts a2 according to the third exposure signal. Then, signal processor 4 determines, for each pixel, the magnitude relationship between A0 and A2, and calculates the following Expressions 3 and 5 according to the determination result (Expressions 2 and 4); in this way, distance L to the subject can be calculated.

[Math. 2]

$$A0 > A2 \qquad \text{(Expression 2)}$$

In this case, distance L to the subject is calculated according to Expression 3.
[Math. 3]

$$L = \frac{c \times To}{2} \times \frac{A1 - A2}{A0 - A2 + A1 - A2} \qquad \text{(Expression 3)}$$

[Math. 4]

$$A2 \geqq A0 \qquad \text{(Expression 4)}$$

In this case, distance L to the subject is calculated according to Expression 5.
[Math. 5]

$$L = \frac{c \times To}{2} \times \frac{A2 - A0}{A1 - A0 + A2 - A0} + \frac{c \times To}{2} \qquad \text{(Expression 5)}$$

Specifically, in Embodiment 1, the distance measurement range (limit) is $c \times T_0/2$, whereas in Variation 1 of Embodiment 1, the distance measurement range (limit) is $2 \times (c \times T_0/2)$, which is twice as wide as that in Embodiment 1.

Thus, in Variation 1 of the present embodiment, in addition to the same advantageous effects produced in Embodiment 1, the advantageous effect of widening the range of three-dimensional detection and measurement is produced because the distance measurement range for the distance image is widened.

VARIATION 2 OF EMBODIMENT 1

In an actual imaging device, the length of the signal period is less than an ideal value because the irradiation light and the exposure signal are not ideal rectangular waves and require a certain transition time. In particular, as the light-emitting element, the laser diode, the light-emitting diode (LED), or the like has a relatively large drive load, and thus tends to have a greater irradiation light transition time and have a shorter signal period than the exposure signal.

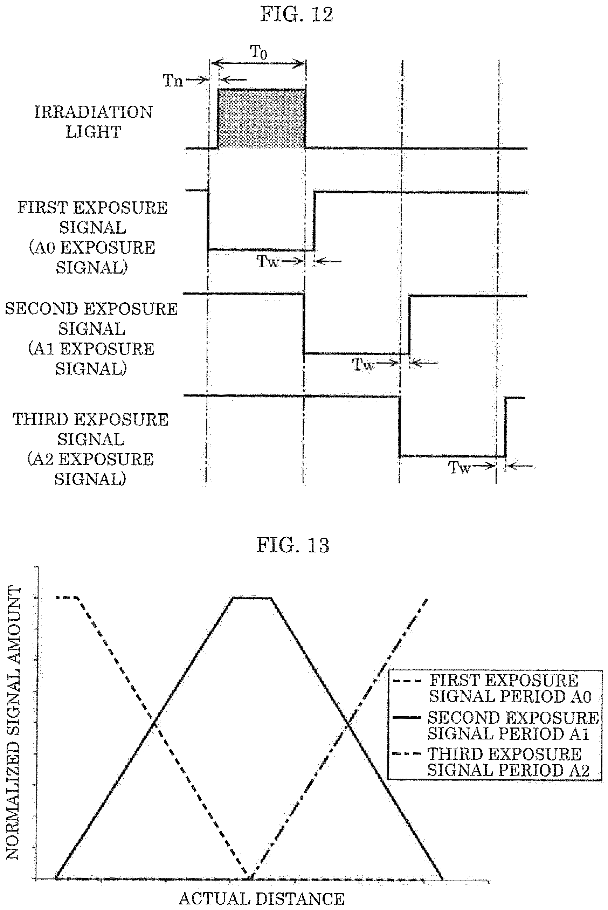

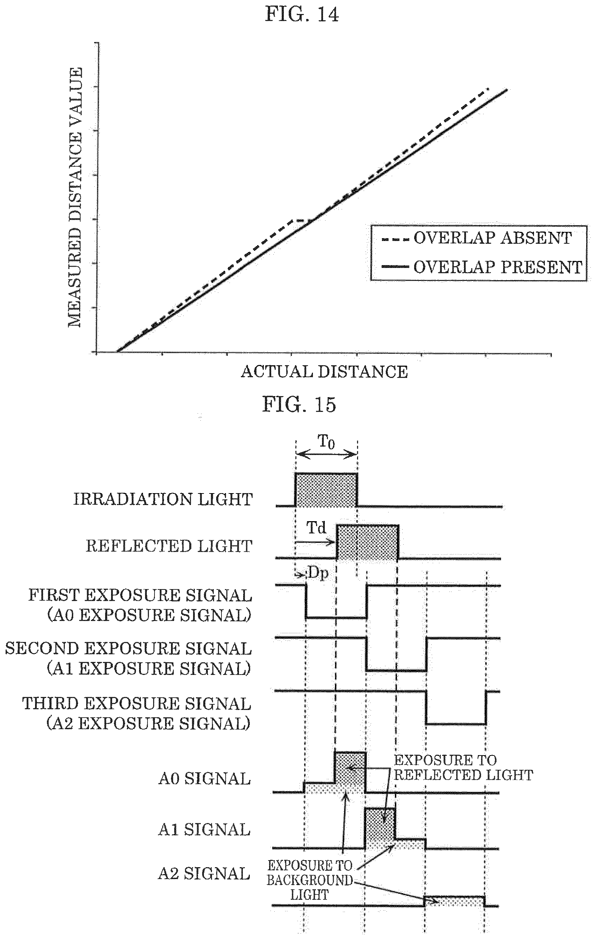

FIG. 12 illustrates an example of the timing for detecting an exposure amount for a distance image frame when the irradiation light signal period of imaging device 10 according to Variation 2 of Embodiment 1 is shorter than an ideal value, FIG. 13 illustrates a change in the exposure amount in the first to third exposure signal periods after normalized with the maximum value, with respect to the actual distance to a subject at the aforementioned timing, and FIG. 14 illustrates the relationship between the actual distance and the measured distance value of the subject at the aforementioned timing.

In the present variation, as illustrated in FIG. 12, the length of the irradiation light signal period is Tn less than the ideal length $T_0$ of the light emission signal period, the end of the first exposure signal (A0 exposure signal) period is shifted backward so that the first exposure signal (A0 exposure signal) period overlaps the second exposure signal (A1 exposure signal) period by Tw, which is added to the ideal length $T_0$ of the light emission signal period, the end of the second exposure signal (A1 exposure signal) period is shifted backward so that the second exposure signal (A1 exposure signal) period overlaps the third exposure signal (A2 exposure signal) period by Tw, which is added to the ideal length $T_0$ of the light emission signal period, and the end of the third exposure signal (A2 exposure signal) period is shifted backward so that the length of the third exposure signal (A2 exposure signal) period is Tw greater than the ideal length $T_0$ of the light emission signal period.

At this time, as illustrated in FIG. 13, there is a period in which the maximum value of the signal amount of total sum A1 of the exposure amounts according to the second exposure signal is flat; if there is no overlap period between the first and second exposure signal periods and between the second and third exposure signal periods, both the numerators and denominators in Expressions 3 and 5 stated above do not change in this flat period, and therefore a period in which the distance measurement value does not change according to the actual distance arises as indicated by the graph "OVERLAP ABSENT" in FIG. 14; however, when the end of each of the first to third exposure signal periods is shifted backward so that overlap period Tw is provided between the first and second exposure signal periods and between the second and third exposure signal periods, as in the present variation, the denominators in Expressions 3 and 5 stated above change according to the actual distance in the period in which the signal amount of total sum A1 of the exposure amounts according to the second exposure signal is flat. Thus, as indicated by the graph "OVERLAP PRESENT" in FIG. 14, the distance measurement value of the subject constantly changes monotonically according to the actual distance in such a way that the linearity is maintained, resulting in high distance measurement accuracy.

Thus, in the present variation, in addition to the same advantageous effects produced in Embodiment 1, the advantageous effect of further increasing the accuracy of three-dimensional detection and measurement is produced because the distance measurement accuracy for the distance image is even higher.

VARIATION 3 OF EMBODIMENT 1

In an actual imaging device, the first delay time, which is delay time until the first exposure signal period starts with respect to the timing at which light source unit 1 emits light in response to the light emission signal from controller 3, will never be 0 and the distance measurement range will never be 0 to $2 \times (c \times T_0/2)$ when in use. Therefore, the first delay time is set in such a way that the distance measurement range becomes no more than $2 \times (c \times T_0/2)$ plus a desired close range.

FIG. 15 illustrates an example of the timing for detecting an exposure amount for a distance image frame in imaging device 10 according to Variation 3 of Embodiment 1.

The difference from Variation 1 of Embodiment 1 is as follows. Specifically, the first delay time, which is delay time until the first exposure signal period starts with respect to the timing at which light source unit 1 emits light in response to the light emission signal from controller 3, is set to Dp. The second delay time, which is delay time until the second exposure signal period starts with respect to the timing at which light source unit 1 emits light in response to the light emission signal from controller 3, is set to $Dp + T_0$, which is the sum of first delay time Dp and first exposure signal period $T_0$. The third delay time, which is delay time until the third exposure signal period starts with respect to the timing at which light source unit 1 emits light in response to the light emission signal from controller 3, is set to $Dp + 2 \times T_0$, which is the sum of first delay time Dp, first exposure signal period $T_0$, and second exposure signal period $T_0$.

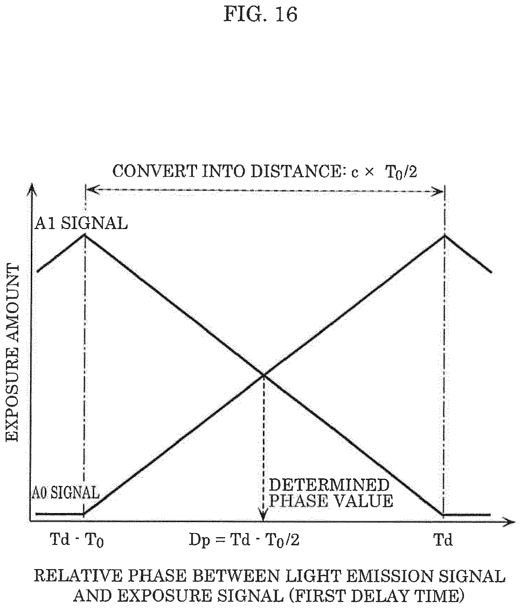

FIG. 16 illustrates the relationship between an exposure amount and the relative phase between a light emission signal and an exposure signal in imaging device 10 according to Variation 3 of Embodiment 1. More specifically, FIG. 16 is a graph plotting changes in the signal amount of total sum A0 of the exposure amounts according to the first exposure signal and changes in the signal amount of total sum A1 of the exposure amounts according to the second exposure signal when only the relative phase between the light emission signal and the exposure signal is scanned, that is, the value of Dp, which is the first delay time, is scanned, at the above timing, while the relationship of the relative phase between the first to third exposure signal periods is fixed in the case where the subject is fixed to 1/4 of a desired distance measurement range, that is, $(c \times T_0/2)/2$ of the distance measurement range. Total sum A0 of the exposure amounts according to the first exposure signal is highest when Dp matches delay Td, which is dependent on the optical path of the reflected light from the subject, with respect to the light emission signal timing (irradiation light); the exposure amount decreases as Dp decreases, and is lowest when Dp is $Td-T_0$. Meanwhile, total sum A1 of the exposure amounts according to the second exposure signal is highest when Dp matches $Td-T_0$; the exposure amount decreases as Dp increases, and is lowest when Dp is Td. When the point at which total sum A0 of the exposure amounts according to the first exposure signal and total sum A1 of the exposure amounts according to the second exposure signal match is selected as Dp, this is $Td - T_0/2$; this means that the relative phase between the light emission signal and the exposure signal is automatically optimized so that the position of the subject is $c \times T_0/2/2$ from the lowest limit of the distance measurement range, that is, 1/4 of the distance measurement range, and thus accurate distance measurement is made possible within a desired range.

Thus, in Variation 3 of the present embodiment, in addition to the same advantageous effects produced in Embodiment 1, the advantageous effect of accurate three-dimensional detection and measurement within a desired range is produced because the distance image is accurate within a desired range.

VARIATION 4 OF EMBODIMENT 1

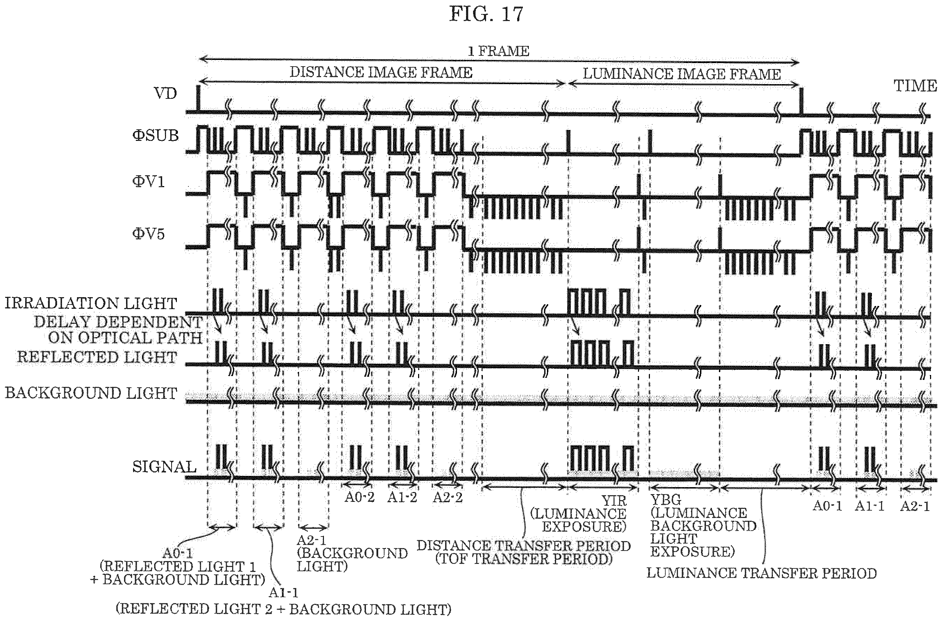

FIG. 17 is a timing chart illustrating an outline of an operation of imaging device 10 according to Variation 4 of Embodiment 1. The difference from Embodiment 1 is that the light emission from light source unit 1 in the luminance exposure period (YIR period) for the luminance image frame is intermittent emission instead of continuous emission, as in the exposure period for the distance image frame.

In the distance measurement method for obtaining a distance image according to the present embodiment, the distance measurement range (limit) described earlier is proportional to length $T_0$ of one light emission signal period for the signal from controller 3, and the accuracy is inversely proportional to $T_0$; thus, length $T_0$ of one light emission signal period is determined according to the required distance measurement range and the required accuracy. Furthermore, in the case of the distance measurement method for obtaining a distance image according to the present embodiment, the duty ratio of the light emission signal is set to 20% in order to avoid aliasing in which, when the subject is distant and the delay dependent on the optical path of the light (reflected light 1, reflected light 2) reflected from the subject with respect to the light emission signal timing (irradiation light) is large, the reflected light (reflected light 1, reflected light 2) is used in the exposure in the next exposure period during repeated exposure and light emission operations.

Meanwhile, since the image quality of the luminance image depends on the amount of light in the exposure, the duty ratio and the length of the light emission signal period for the light emitted from light source unit 1 in the luminance exposure period (YIR period) for the luminance image frame are set according to the type of the light source included in light source unit 1 in such a way that the light emission intensity becomes highest.

As described above, in Variation 4 of Embodiment 1, in addition to the same advantageous effects produced in Embodiment 1, the duty ratio and the length of the light emission signal period for the light emitted from light source unit 1 in the exposure period for obtaining a luminance image and the duty ratio and the length of the light emission signal period for the light emitted from light source unit 1 in the exposure period for obtaining a distance image can be set independently according to the type of the light source so that the light emission intensity becomes highest. Thus, the advantageous effect of providing a luminance image having even higher image quality is produced.

In other words, the light emission duty ratio in the exposure period for obtaining signals of the luminance image does not depend on the method for obtaining signals of the distance image, and thus settings for optimizing the light emission intensity of the light source are possible.

VARIATION 5 OF EMBODIMENT 1

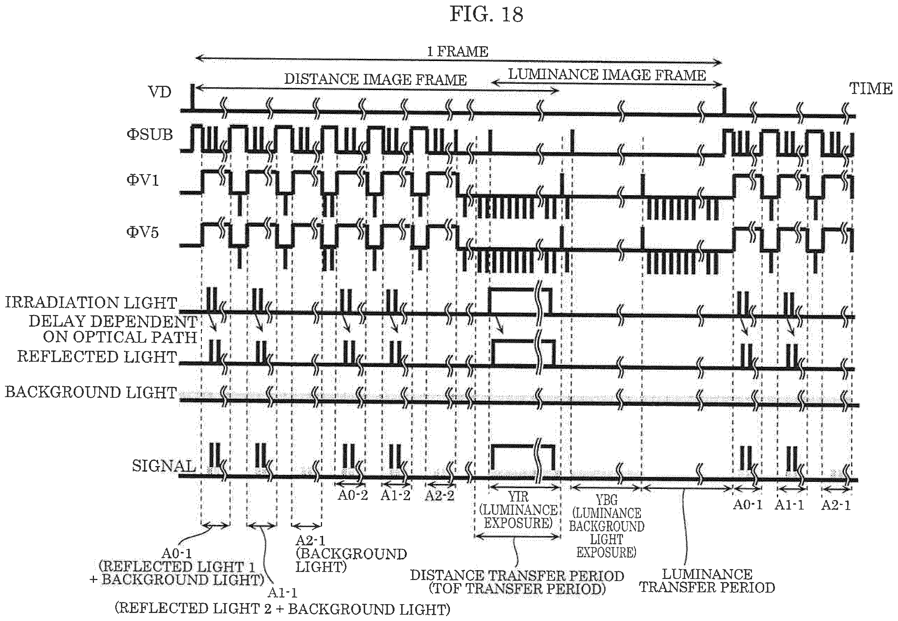

FIG. 18 is a timing chart illustrating an outline of an operation of imaging device 10 according to Variation 5 of Embodiment 1. The difference from Embodiment 1 is that the luminance exposure period (YIR period) for the luminance image frame overlaps the distance transfer period in the distance image frame. Specifically, after a lapse of a predetermined time since the end of the light emission from light source unit 1, $\varphi$V1 and $\varphi$V5 are set to the high level and readout gates 22 are opened. Accordingly, so that the timing at which the charges accumulated in light-receiving regions 21 are read out to the packets under gates V1 and V5 which are readout gates 22 of vertical transfer portion 23 comes later than completion of the TOF transfer, all the charges accumulated in light-receiving regions 21 are discharged first to the semiconductor substrate (the outside) before the start of exposure, and the operation of setting exposure signal $\varphi$SUB from controller 3 to the high level first and then returning exposure signal $\varphi$SUB to the low level, which is the operation of determining the start of exposure, is set within the distance transfer period in such a way that a desired exposure period is obtained.

As described above, in Variation 5 of Embodiment 1, in addition to the same advantageous effects produced in Embodiment 1, the frame rate (the number of frames per second) increases, the time difference between the exposure period for the distance image and the exposure period for the luminance image is reduced, and the accuracy of three-dimensional detection and measurement of a subject that moves fast can be increased.

VARIATION 6 OF EMBODIMENT 1

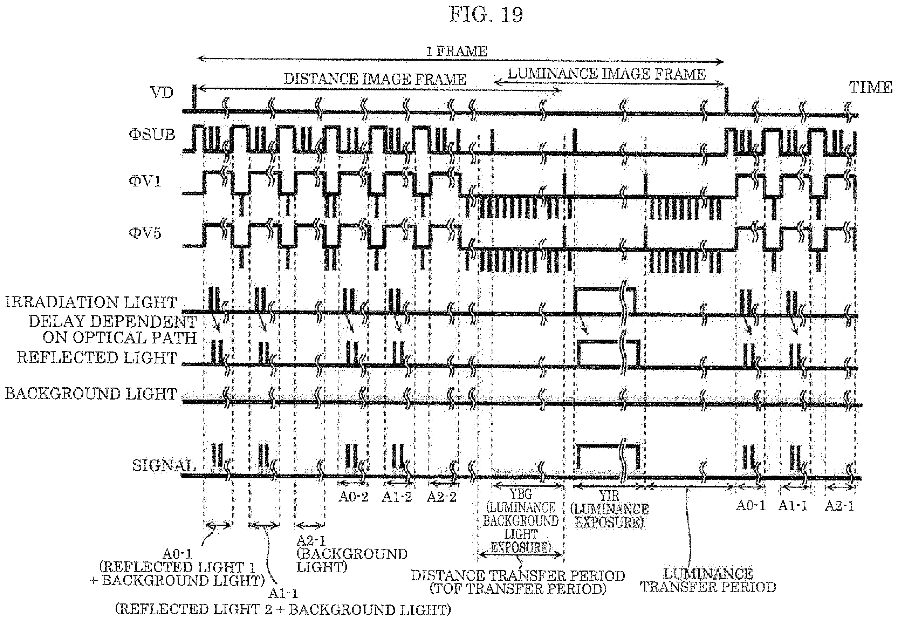

FIG. 19 is a timing chart illustrating an outline of an operation of imaging device 10 according to Variation 6 of Embodiment 1. The difference from Variation 5 of Embodiment 1 is that the order of the luminance exposure period (YIR period) and the luminance background light exposure period (YBG period) for the luminance image frame is switched and that the luminance background light exposure period (YBG period) overlaps the distance transfer period in the distance image frame.

With this, in Variation 6 of Embodiment 1, in addition to the same advantageous effects produced in Variation 5 of Embodiment 1, the advantageous effect of reducing generation of unnecessary charges due to light entering vertical transfer portion 23, that is, reducing the occurrence of what is called smear from being superimposed on the distance image, is produced because the light emission from light source unit 1 is stopped in the distance transfer period.

VARIATION 7 OF EMBODIMENT 1

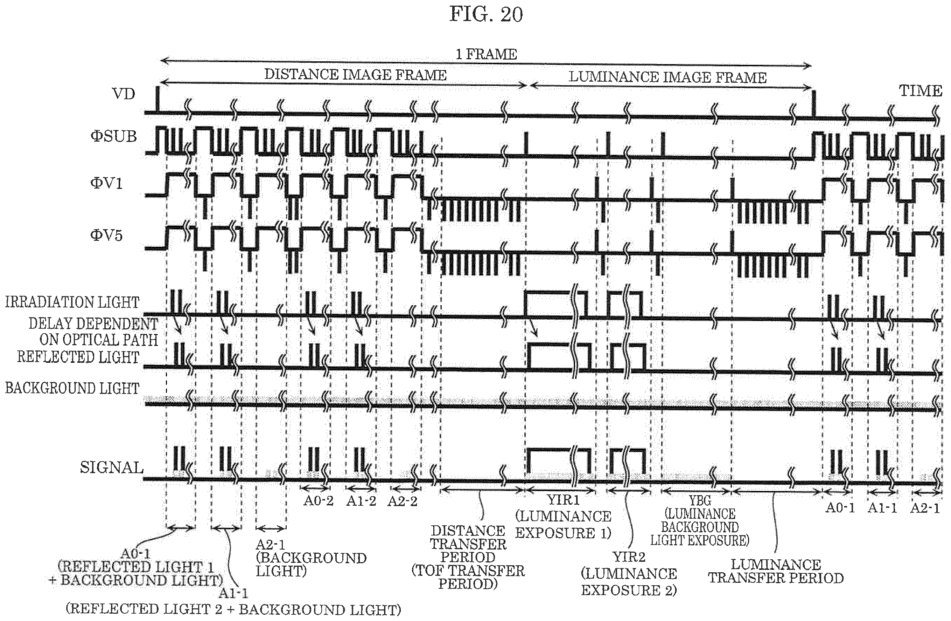

FIG. 20 is a timing chart illustrating an outline of an operation of imaging device 10 according to Variation 7 of Embodiment 1. The difference from Embodiment 1 is that in the luminance image frame, the luminance exposure period includes two different types of exposure periods having different lengths of light emission periods for light source unit 1 and different lengths of exposure periods, namely, luminance exposure period 1 and luminance exposure period 2.

Specifically, as illustrated in FIG. 20, in the first luminance exposure period (YIR1 period) for the luminance image frame, in the state where $\varphi$V1 and $\varphi$V5 are set to the middle level and readout gates 22 are closed, exposure signal $\varphi$SUB from controller 3 is set to the high level first, and then all the charges accumulated in light-receiving regions 21 are discharged to the semiconductor substrate (the outside). Thereafter, exposure signal $\varphi$SUB returns to the low level.

Next, light source unit 1 emits light continuously for a predetermined time according to the light emission signal generated at controller 3, light-receiving regions 21 are exposed to the reflected light from the subject, and charges are accumulated. Subsequently, after a lapse of a predetermined time since the end of the light emission from light source unit 1, φV1 and φV5 are set to the high level, readout gates 22 are opened, and the charges accumulated in light-receiving regions 21 are read out to the packets under gates V1 and V5 which are readout gates 22 of vertical transfer portion 23. When the readout is complete, φV1 and φV5 are set to the middle level and readout gates 22 are closed, and the gates of vertical transfer portion 23 are controlled. With this, the signal charges accumulated in vertical transfer portion 23 in the YIR1 period are transferred forward through vertical transfer portion 23 to the packet under a gate at which readout gate 22 is not present; thus, the signal charges under gates V1 and V5 drain. The length of time from the end of the light emission from light source unit 1 until φV1 and φV5 are set to the high level may be set in consideration of the delay dependent on the optical path of reflected light from the most distant subject among subjects the images of which are desired to be captured. Here, the exposure period starts from the point at which exposure signal φSUB from controller 3 changes from the high level to the low level and ends at the point at which φV1 and φV5 are set to the high level and readout gates 22 are opened. Therefore, the signal charges accumulated through this exposure are attributed to the reflected light from the subject and the background light in the exposure period, resulting in an image indicated by SIGNAL in FIG. 20.

Subsequently, as illustrated in FIG. 20, in the second luminance exposure period (YIR2 period) for the luminance image frame, in the state where φV1 and φV5 are set to the middle level and readout gates 22 are closed, exposure signal φSUB from controller 3 is set to the high level first, and then all the charges accumulated in light-receiving regions 21 are discharged to the semiconductor substrate (the outside). Thereafter, exposure signal φSUB returns to the low level.

Next, light source unit 1 emits light continuously for a predetermined time different from that in the first luminance exposure period (YIR1 period) according to the light emission signal generated at controller 3, light-receiving regions 21 are exposed to the reflected light from the subject, and charges are accumulated. Subsequently, after a lapse of a predetermined time since the end of the light emission from light source unit 1, φV1 and φV5 are set to the high level, readout gates 22 are opened, and the charges accumulated in light-receiving regions 21 are read out to the packets under gates V1 and V5 which are readout gates 22 of vertical transfer portion 23. When the readout is complete, φV1 and φV5 are set to the middle level and readout gates 22 are closed, and the gates of vertical transfer portion 23 are controlled. This causes the signal charges accumulated in vertical transfer portion 23 in the YIR1 period and the YIR2 period to be transferred forward through vertical transfer portion 23 to the packet under a gate at which readout gate 22 is not present; thus, the signal charges under gates V1 and V5 drain again. The length of time from the end of the light emission from light source unit 1 until φV1 and φV5 are set to the high level may be set in consideration of the delay dependent on the optical path of reflected light from the most distant subject among subjects the images of which are desired to be captured, similar to the first luminance exposure period (YIR1 period). Here, similar to the first luminance exposure period (YIR1 period), the exposure period starts from the point at which exposure signal φSUB from controller 3 changes from the high level to the low level and ends at the point at which φV1 and φV5 are set to the high level and readout gates 22 are opened, and the length of the exposure period is different from that in the first luminance exposure period (YIR1 period). Therefore, the signal charges accumulated through this exposure are attributed to the reflected light from the subject and the background light in the exposure period, resulting in an image indicated by SIGNAL in FIG. 20.

Subsequently, as illustrated in FIG. 20, in the luminance background light exposure period (YBG period) for the luminance image frame, in the state where φV1 and φV5 are set to the middle level and readout gates 22 are closed, exposure signal φSUB from controller 3 is set to the high level first, and then all the charges accumulated in light-receiving regions 21 are discharged to the semiconductor substrate (the outside). Thereafter, exposure signal φSUB returns to the low level.

Next, the light emission from light source unit 1 is stopped, light-receiving regions 21 are exposed, charges are accumulated, and after a lapse of a predetermined time, φV1 and φV5 are set to the high level, readout gates 22 are opened, and the charges accumulated in light-receiving regions 21 are read out to the packets under gates V1 and V5 which are readout gates 22 of vertical transfer portion 23. When the readout is complete, φV1 and φV5 are set to the middle level and readout gates 22 are closed.

At this time, the three types of signals, i.e., the signal charges accumulated in the YIR1 period, the signal charges accumulated in the YIR2 period, and the signal charges accumulated in the YBG period, are not mixed up and are independently stored in the packets in vertical transfer portion 23.

Here, the exposure period in the luminance background light exposure period (YBG period) starts from the point at which exposure signal φSUB from controller 3 changes from the high level to the low level and ends at the point at which φV1 and φV5 are set to the high level and readout gates 22 are opened. In the present embodiment, the exposure period in this luminance background light exposure period (YBG period) is set to have the same length as the exposure period in the first luminance exposure period (YIR1 period). Therefore, the signal charges accumulated through this exposure are attributed to the background light in the exposure period, and the exposure amount is the same as that of the background light included in the signals obtained through the exposure in the first luminance exposure period (YIR1 period), and is different only for the difference in the length of the exposure period from the background light included in the signals obtained through the exposure in the second luminance exposure period (YIR2 period), resulting in an image indicated by SIGNAL in FIG. 20.

Thereafter, the transfer in vertical transfer portion 23 and the transfer in horizontal transfer portion 24 are repeatedly performed sequentially in the luminance transfer period, and output amplifier 25 converts the charges into a voltage signal and outputs the voltage signal to signal processor 4 as an imaging signal. Signal processor 4 performs, in the calculation for obtaining a luminance image, combination of the signals obtained through the exposure in the first luminance exposure period (YIR1 period) and the signals obtained through the exposure in the second luminance exposure period (YIR2 period), and subtraction of the signals obtained through the exposure in the luminance background light exposure period (YBG period) in consideration of differences between the lengths of the exposure periods.

Thus, in Variation 7 of Embodiment 1, in addition to the same advantageous effects produced in Embodiment 1, high quality luminance images of close to distant subjects can be obtained because saturation, in a luminance image, of especially a subject close to the light source unit can be suppressed.

EMBODIMENT 2

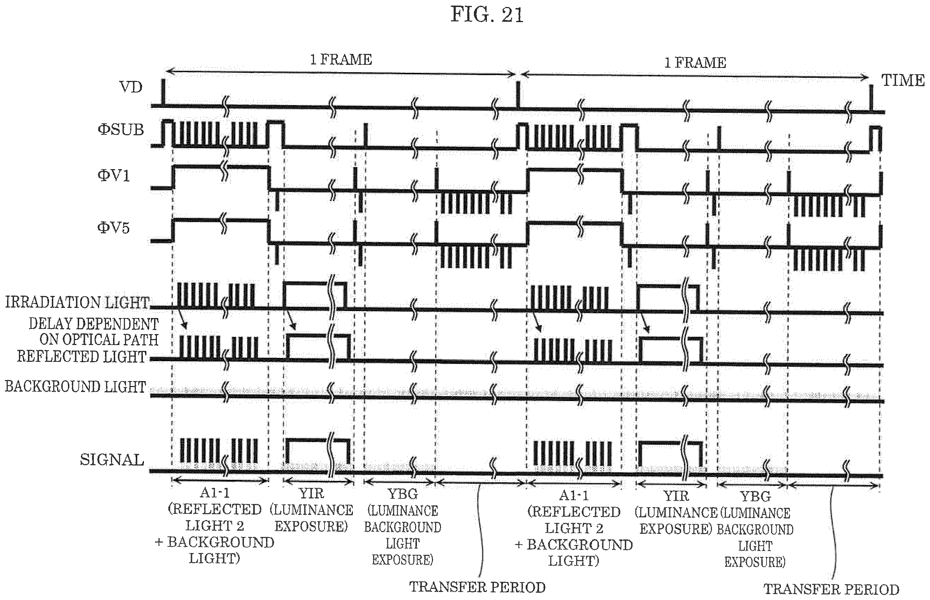

FIG. 21 is a timing chart illustrating an outline of an operation of imaging device 10 according to Embodiment 2. Specifically, FIG. 21 illustrates an example of the drive timing in which the signal charges generated in two horizontally adjacent light-receiving regions 21 are read out to vertical transfer portion 23 and transferred in the vertical direction within one frame period.

FIG. 21 illustrates: vertical synchronization pulse VD; φSUB which is an exposure signal; φV1 and φV5 among gates V1 to V8 included in vertical transfer portion 23 that are used along with readout gates 22; infrared light (irradiation light) emitted from light source unit 1; reflected light that is light reflected by the subject; background light; and SIGNAL indicating an image of the signal charge generated in light-receiving region 21. The difference from Embodiment 1 is that one frame period includes three types of exposure periods, namely, the second light emission/exposure period (A1 period), the luminance exposure period (YIR period), and the luminance background light exposure period (YBG period), and that the exposure for obtaining signals of the distance image is performed only in the second light emission/exposure period (A1 period). The signal charges obtained through these three different types of exposure are stored into the packets in vertical transfer portion 23 and transferred in one transfer period.

Specifically, vertical synchronization pulse VD has more than one frame per second, and each frame period includes the second light emission/exposure period (A1 period), the luminance exposure period (YIR period), the luminance background light exposure period (YBG period), and a transfer period in which three types of signals accumulated through these three types of exposure are transferred and imaging signals are output to signal processor 4.

The second light emission/exposure period (A1 period) has a different phase with respect to the timing for emitting light from light source unit 1 according to the light emission signal generated at controller 3; in this period, light-receiving regions 21 are exposed according to the timing of exposure signal φSUB from controller 3 which indicates exposure to the reflected light that is delayed according to the distance to the subject.

In the luminance exposure period (YIR period), light source unit 1 emits light according to the light emission signal generated at controller 3, and light-receiving regions 21 are exposed to the reflected light from the subject.

In the luminance background light exposure period (YBG period), the light emission from light source unit 1 is stopped, and light-receiving regions 21 are exposed only to the background light.

In the transfer period, three types of signals accumulated through these three types of exposure are transferred, and the imaging signals are output to signal processor 4.

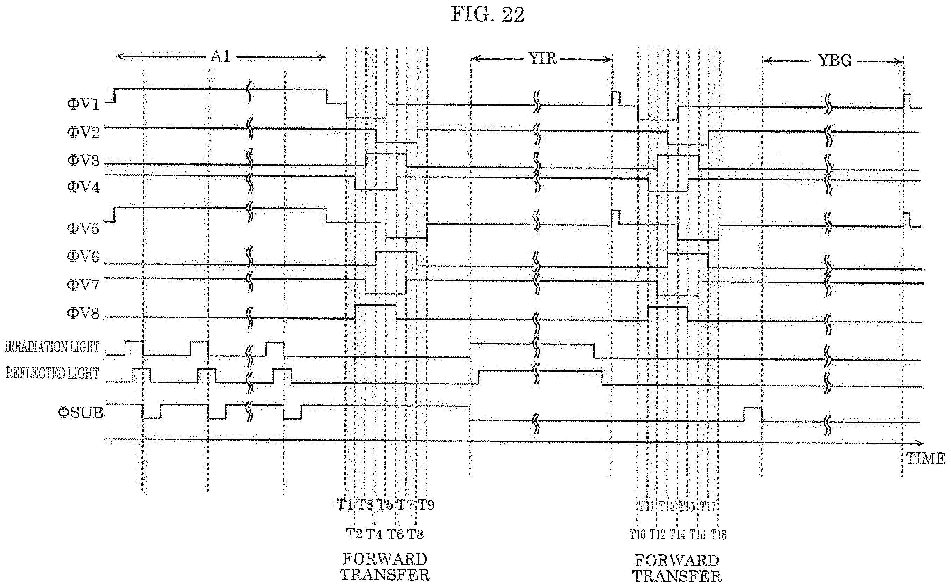

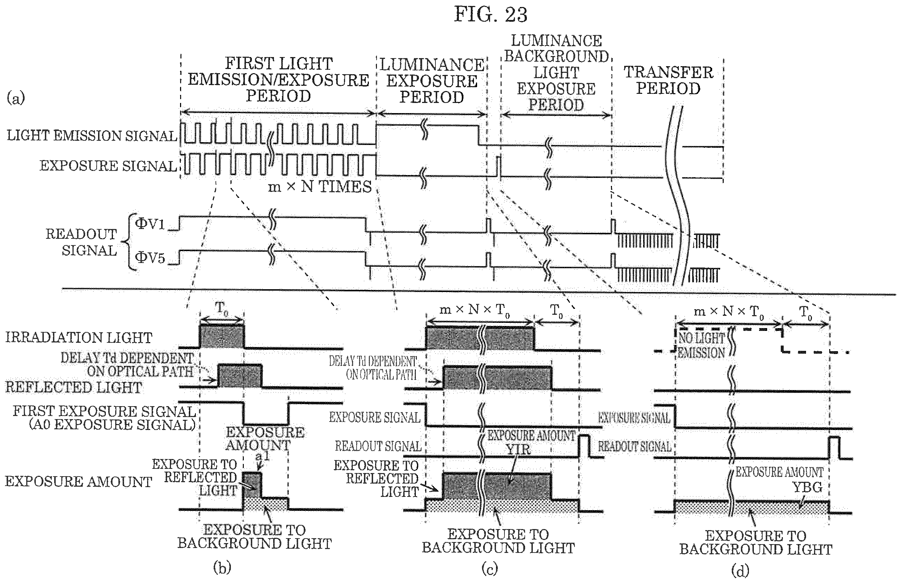

FIG. 22 is a timing chart illustrating an operation of imaging device 10 according to Embodiment 2 in detail. FIG. 23 illustrates an example of the timing for detecting an exposure amount in imaging device 10 according to Embodiment 2.

Specifically, FIG. 23 illustrates, in (a), an example of the timing relationship in one frame between the light emission signal (irradiation light), the exposure signal (φSUB), and the readout signals (φV1 and φV5), which controller 3 outputs. FIG. 23 illustrates, in (b), the timing for detecting exposure amount a1 in the second light emission/exposure period (A1 period). FIG. 23 illustrates, in (c), the timing for detecting total sum YIR of exposure amounts in the luminance exposure period (YIR period). FIG. 23 illustrates, in (d), the timing for detecting total sum YBG of exposure amounts in the luminance background light exposure period (YBG period).

As illustrated in FIG. 21 and FIG. 22, in the second light emission/exposure period (A1 period), in the state where φV1 and φV5 are set to the high level and readout gates 22 are open, light-receiving region 21 receives exposure signal φSUB from controller 3 after the second delay time and performs exposure in the low level period with respect to the timing at which light source unit 1 emits light in response to the light emission signal from controller 3. In the present embodiment, as illustrated in FIG. 23, the length of the second exposure signal (φSUB is at the low level) period and the second delay time are set to To, which is the same as the length of the light emission signal period.

In the present embodiment, as illustrated in FIG. 23, the second light emission and exposure are repeated m × N times so that the total exposure time becomes equal to that in Embodiment 1, and charges generated by the exposure are accumulated in the packets under gates V1 and V5 which are readout gates 22 of vertical transfer portion 23. Thereafter, $\varphi$V1 and $\varphi$V5 are set to the middle level and readout gates 22 are closed, and pulses $\varphi$V1 to $\varphi$V8 indicated at time T1 to time T9 in FIG. 22 are applied. This causes the signal charges accumulated in vertical transfer portion 23 in the A1 period to be transferred forward through vertical transfer portion 23 to the packet under a gate at which readout gate 22 is not present; thus, the signal charges under gates V1 and V5 drain.

Subsequently, as illustrated in FIG. 21 and FIG. 22, in the luminance exposure period (YIR period), in the state where $\varphi$V1 and $\varphi$V5 are set to the middle level and readout gates 22 are closed, all the charges accumulated in light-receiving regions 21 are discharged to the semiconductor substrate (the outside). Thereafter, exposure signal $\varphi$SUB from controller 3 is set to the low level. Next, light source unit 1 emits light continuously for a predetermined time according to the light emission signal generated at controller 3, light-receiving regions 21 are exposed to the reflected light from the subject, and charges are accumulated. Subsequently, after a lapse of a predetermined time since the end of the light emission from light source unit 1, $\varphi$V1 and $\varphi$V5 are set to the high level, readout gates 22 are opened, and the charges accumulated in light-receiving regions 21 are read out to the packets under gates V1 and V5 which are readout gates 22 of vertical transfer portion 23. When the readout is complete, $\varphi$V1 and $\varphi$V5 are set to the middle level and readout gates 22 are closed, and pulses $\varphi$V1 to $\varphi$V8 indicated at time T1 to T10 in FIG. 22 are applied. This causes the signal charges accumulated in vertical transfer portion 23 in the A1 period and the signal charges accumulated in the YIR period to be transferred forward through vertical transfer portion 23 to the packet under a gate at which readout gate 22 is not present; thus, the signal charges under gates V1 and V5 drain again. The length of time from the end of the light emission from light source unit 1 until $\varphi$V1 and $\varphi$V5 are set to the high level may be set in consideration of the delay dependent on the optical path of reflected light from the most distant subject among subjects the images of which are desired to be captured. Here, the exposure period starts from the point at which exposure signal $\varphi$SUB from controller 3 is set to the low level and ends at the point at which $\varphi$V1 and $\varphi$V5 are set to the high level and readout gates 22 are opened. Therefore, the signal charges accumulated through this exposure are attributed to the reflected light from the subject and the background light in the exposure period, resulting in an image indicated by SIGNAL in FIG. 21. In the present embodiment, as illustrated in FIG. 23, the period in which light source unit 1 emits light is set to m × N × $T_0$, and the length of time from the end of the light emission from light source unit 1 until $\varphi$V1 and $\varphi$V5 are set to the high level is set to $T_0$, and thus the length of the exposure period is set to (m × N + 1) × $T_0$.

Subsequently, as illustrated in FIG. 21 and FIG. 22, in the luminance background light exposure period (YBG period), in the state where $\varphi$V1 and $\varphi$V5 are set to the middle level and readout gates 22 are closed, exposure signal $\varphi$SUB from controller 3 is set to the high level first, and then all the charges accumulated in light-receiving regions 21 are discharged to the semiconductor substrate (the outside). Thereafter, exposure signal $\varphi$SUB returns to the low level. Next, the light emission from light source unit 1 is stopped, light-receiving regions 21 are exposed, charges are accumulated, and after a lapse of a predetermined time, $\varphi$V1 and $\varphi$V5 are set to the high level, readout gates 22 are opened, and the charges accumulated in light-receiving regions 21 are read out to the packets under gates V1 and V5 which are readout gates 22 of vertical transfer portion 23. When the readout is complete, $\varphi$V1 and $\varphi$V5 are set to the middle level and readout gates 22 are closed.

At this time, the three types of signals, i.e., the signal charges accumulated in the A1 period, the signal charges accumulated in the YIR period, and the signal charges accumulated in the YBG period, are not mixed up and are independently stored in the packets in vertical transfer portion 23.

Here, the exposure period in the luminance background light exposure period (YBG period) starts from the point at which exposure signal $\varphi$SUB from controller 3 changes from the high level to the low level and ends at the point at which $\varphi$V1 and $\varphi$V5 are set to the high level and readout gates 22 are opened. In the present embodiment, the length of the exposure period in the luminance background light exposure period (YBG period) is set to (m × N + 1) × $T_0$, which is the same as the length of the exposure period in the luminance exposure period (YIR period), as in FIG. 23. Therefore, the signal charges accumulated through this exposure are attributed to the background light in the exposure period, and the exposure amount is the same as that of the background light included in the signals obtained through the exposure in the luminance exposure period (YIR period), resulting in an image indicated by SIGNAL in FIG. 21.

Thereafter, the transfer in vertical transfer portion 23 and the transfer in horizontal transfer portion 24 are repeatedly performed sequentially in the transfer period, and output amplifier 25 converts the charges into a voltage signal and outputs the voltage signal to signal processor 4 as an imaging signal. Signal processor 4 subtracts, in the calculation for obtaining a luminance image, the signals obtained through the exposure in the luminance background light exposure period (YBG period) from the signals obtained through the exposure in the luminance exposure period (YIR period).

In the imaging operation using signals YIR and YBG for obtaining a luminance image, readout gates 22 are open only when the charges are read out from light-receiving regions 21 to vertical transfer portion 23. Thus, it is possible to obtain a high-quality luminance image in which the amount of noise attributable to time during which readout gates 22 are open is small.

Subsequently, with reference to FIG. 23, the distance measurement operation using signals for obtaining a distance image in imaging device 10 according to the present embodiment will be described in detail.

FIG. 23 illustrates, in (a), an example of the timing relationship in one screen between the light emission signal (irradiation light), the exposure signal ($\varphi$SUB), and the readout signal ($\varphi$V1 and $\varphi$V5). In the present embodiment, the number of repetitions of the light emission signal and the exposure signal in the second light emission/exposure period (A1 period) is $m \times N$, the period in which light source unit 1 emits light in the luminance exposure period (YIR period) is $m \times N \times T_0$, the length of time from the end of the light emission from light source unit 1 until $\varphi$V1 and $\varphi$V5 are set to the high level is $T_0$, the length of the exposure period is $(m \times N + 1) \times T_0$, and the length of the exposure period in the luminance background light exposure period (YBG period) is $(m \times N + 1) \times T_0$.

Here, let A1 be the total sum of exposure amounts a1 according to the second exposure signal, YIR be the total sum of exposure amounts in the luminance exposure period, and YBG be the total sum of exposure amounts in the luminance background light exposure period. In the present embodiment, the total period in which light is emitted in the second light emission/exposure period and the period in which light is emitted in the luminance exposure period are both $m \times N \times T_0$ when the rise time and the fall time of the light emission signal (irradiation light) and the exposure signal (cpSUB) are zero. Thus, the result of subtracting YBG from YIR is equal to the total obtained through exposure to the entire reflected light of the light emitted in the second light emission/exposure period, and the background light included in A1 is $(m \times N) / (m \times N + 1)$ times YBG. However, since actual light emission signals (irradiation light) and exposure signals ($\varphi$SUB) have rise time and fall time, even when the number of repetitions of period $T_0$ is $m \times N$ times, the total period will not be necessarily the same time amount as continuation of $m \times N \times T_0$. Therefore, correction for the difference is necessary; assume that a correction coefficient is a. Thus, signal processor 4 can calculate distance L to the subject by calculating, for each pixel, the following Expression 6 where c is the speed of light (299,792,458 m/s). [Math. 6]

$$L = \frac{c \times To}{2} \times \frac{a \times A1 - YBG \times (m \times N) / (m \times N + 1)}{YIR - YBG} \qquad \text{(Expression 6)}$$

Note that this calculation may be performed using the signals obtained in Embodiment 1 and the variations thereof.

In Expression 6 stated above, in the imaging operation of obtaining A1, the value which varies according to the distance to the subject, in the state where $\varphi$V1 and $\varphi$V5 are set to the high level and readout gates 22 are open, the exposure is controlled using only signals $\varphi$SUB for controlling the substrate voltage (SUB), and thus all light-receiving regions 21 can be subject to accurate, high-speed exposure control at the same time. Therefore, the accuracy of A1 in Expression 6 stated above increases, and thus it is possible to provide signals for obtaining an accurate distance image.

Furthermore, in Expression 6 stated above, in the imaging operation of obtaining YIR and YBG, the values of which do not vary according to the distance to the subject, readout gates 22 are open only when charges are read out from light-receiving regions 21 to vertical transfer portion 23; thus, the amount of noise attributable to time during which readout gates 22 are open is small, and the deviation of distance L which is determined by the calculation is small.

As described above, in the present embodiment, in addition to the same advantageous effects produced in Embodiment 1, the deviation of distance L which is determined by the calculation is small; thus, the accuracy of the distance image further increases, and more accurate three-dimensional detection and measurement can be made possible.

Furthermore, the frame rate (the number of frames per second) increases, and the time difference between the exposure period for the distance image and the exposure period for the luminance image is reduced; thus, the accuracy of three-dimensional detection and measurement of a subject that moves fast can be increased.

CONCLUSION

Note that out of the TOF methods, the rectangular-wave TOF method in which the repetition of light emission and exposure includes a phase in which no exposure is performed is exemplified as the method for obtaining a distance image in each of the above embodiments, but the method for obtaining a distance image is not limited to the rectangular-wave TOF method. It is possible to use other methods such as a modulation TOF method (irradiation light with sine waves) and a rectangular-wave modulation TOF method (irradiation light with rectangular waves) in which a distance image is obtained by calculation from signals obtained at four-phase exposure timings with different phases at every 90 degrees using a light source modulated for sine waves or rectangular waves, and furthermore a pattern irradiation method in which a distance is calculated through image processing based on the amount of movement of a projected pattern including individual random dots projected onto a subject.

Furthermore, the CCD image sensor is used as a solid-state imaging element in the above-described embodiment, but the solid-state imaging element which is used in the present invention is not limited to the CCD image sensor; it is possible to obtain the advantageous effects of the present invention even when other image sensors (as an example, a CMOS image sensor or an image sensor including a photoelectric conversion film) are used. Note that in the present embodiment, an image sensor in which a charge is converted into a voltage inside pixel 27 is referred to as a CMOS image sensor.

FIG. 24 illustrates a configuration of a CMOS image sensor as an example of solid-state imaging element 20 according to the present embodiment; imager 2 includes this solid-state imaging element 20. Herein, only the part encompassing two pixels in the vertical direction and two pixels in the horizontal direction is illustrated to facilitate understanding of the present invention. Note that in comparison between the CMOS image sensor (FIG. 24) and the CCD image sensor (FIG. 2A) according to the present embodiment, light-receiving region 31 in FIG. 24 corresponds to light-receiving region 21 in FIG. 2A, charge accumulator 32 in FIG. 24 corresponds to vertical transfer portion 21 in FIG. 2A, and reader 36 in FIG. 24 corresponds to readout gate 22.

As illustrated in FIG. 24, the CMOS image sensor includes: a plurality of light-receiving regions (light receivers or photoelectric converters; for example, photodiodes) 31; overflow drain 34 which is provided on each light-receiving region 31 and discharges unnecessary charges via exposure controller 33 which controls exposure; charge accumulator 32 which accumulates charges shared between horizontally adjacent light-receiving regions 31 via a plurality of (for example, two) readers 36 which control readout of the charges; and transfer controller 35 which is provided between two adjacent charge accumulators 32 on the same side of light-receiving region 31 and controls transfer of the charges, and an end of one of two adjacent charge accumulators 32 that is opposite to transfer controller 35 is connected via outputter 38 to floating diffusion 37 which converts, into voltages, the charges shared with other adjacent charge accumulators 32.

Here, in the distance image frame, in each light-receiving region 31, charges generated through exposure in the exposure signal periods at different timings with respect to the timing at which light source unit 1 emits light in response to the light emission signal from controller 3 are accumulated in different charge accumulators 32 and then converted into voltages by floating diffusion 37 through control of transfer controller 35 and outputter 38 before being sequentially output. On the other hand, in the luminance image frame, exposure controller 33 and output control are linearly sequentially scanned (what is called rolling shutter), and thus the charges generated in light-receiving region 31 do not stay in charge accumulator 32, but are directly converted into voltages at floating diffusion 37, and then sequentially output; thus, image deterioration due to noise attributable to the charges staying in the charge accumulator 32 does not occur.

Therefore, even when the CMOS image sensor is used as the solid-state imaging element, the advantageous effects of the present invention can be obtained as in the case where the CCD image sensor is used.

Furthermore, the above embodiments exemplify the luminance image as being obtained by light emission from light source unit 1 in the exposure period, but the light does not need to be emitted in the exposure period.

Furthermore, the above embodiments exemplify the background light as being used in the exposure (being received) in order to increase the distance measurement accuracy, but the advantageous effects of the present invention can be obtained even when the background light is not used in the exposure (not being received), but only the irradiation light is used in the exposure (is received).

Furthermore, although the above embodiments have described the imaging device, the configuration of the imaging device according to the present disclosure is applicable not only to an imaging device which measures a distance using distance information, but also a physical quantity detection device which accurately detects other physical quantities (for example, shape, temperature, and radiodensity) and an imaging device which accurately renders data of a captured image, for example.

OTHER EMBODIMENTS

Although the imaging devices and solid-state imaging elements according to the present disclosure have been described thus far based on the above embodiments and variations thereof, the imaging devices and solid-state imaging elements according to the present disclosure are not limited to the embodiments and variations thereof described above. The present invention includes other embodiments implemented through a combination of arbitrary structural elements of the above embodiments and variations thereof, or variations obtained through the application of various modifications to the above embodiments and variations thereof that may be conceived by a person having ordinary skill in the art, without departing from the essence of the present invention, and various devices in which the imaging device and solid-state imaging element according to the present disclosure are built-in.

INDUSTRIAL APPLICABILITY

The imaging device according to the present invention enables accurate three-dimensional detection and measurement of a subject without depending on the surrounding environment, and is thus useful, for example, for stereoscopic detection, display, and rendering of the forms of persons, buildings, and organs and tissues of human bodies, animals, and plants using a point cloud and the like, and eye gaze detection, gesture recognition, obstacle detection, road surface detection, and the like.

REFERENCE MARKS IN THE DRAWINGS

1 light source unit
2 imager
3 controller
3A exposure signal controller
3B light emission signal controller
4 signal processor
10 imaging device
20 solid-state imaging element
21 light-receiving region (light receiver, photoelectric converter)
22 readout gate (reader)
23 vertical transfer portion (first transfer portion, signal accumulator)
24 horizontal transfer portion (second transfer portion, signal accumulator)
25 output amplifier
26 SUB terminal
27 pixel
28 channel stop
29 vertical over flow drain
31 light-receiving region (light receiver, photoelectric converter)
32 charge accumulator (signal accumulator, transfer portion)
33 exposure controller
34 overflow drain
35 transfer controller
36 reader
37 floating diffusion
38 outputter

## Claims

1. An imaging device comprising:

   a controller which generates a light emission signal and an exposure signal, the light emission signal instructing emission of irradiation light, the exposure signal instructing exposure to reflected light from an object;
   a light source unit configured to emit the irradiation light according to the light emission signal;
   an imager including a solid-state imaging element which includes a plurality of pixels, performs exposure a plurality of times according to the exposure signal, performs image capture in which signals are accumulated in different ones of a plurality of signal accumulators among the plurality of pixels, and outputs an imaging signal corresponding to the image capture; and
   a signal processor which outputs a distance image and a luminance image according to calculation based on a signal amount of the imaging signal,
   wherein the imaging signal includes a distance imaging signal for obtaining the distance image by calculation and a luminance imaging signal for obtaining the luminance image by calculation,
   the solid-state imaging element generates the distance imaging signal and the luminance imaging signal from a same one of the plurality of pixels, and
   in a period in which the solid-state imaging element performs the exposure to obtain the luminance imaging signal, the light source unit emits the irradiation light according to a timing indicated by the light emission signal, as in a period in which the solid-state imaging element performs the exposure to obtain the distance imaging signal.

2. The imaging device according to claim 1,
   wherein the controller sets timings of the exposure signal for the exposure for at least two of the plurality of signal accumulators that are different among the plurality of pixels, the timings being different from each other with respect to a timing of the light emission signal and providing an overlap period.

3. The imaging device according to claim 1 or 2,
   wherein the controller sets timings of the exposure signal for performing the exposure for at least two of the plurality of signal accumulators that are different among the plurality of pixels, the timings being different from each other with respect to a timing of the light emission signal and causing a phase relationship between the light emission signal and the exposure signal to be adjusted to equalize amounts of the exposure to the reflected light from the object placed within a distance measurement range from which the distance image is obtained.

4. The imaging device according to any one of claims 1 to 3,
   wherein the signal processor performs three-dimensional object detection or object measurement by calculation using the distance image and the luminance image.

5. The imaging device according to any one of claims 1 to 4,
   wherein a method for obtaining the distance image is a time of flight (TOF) method.

6. The imaging device according to any one of claims 1 to 5,
   wherein the controller divides at least one of an exposure period in which the signals are accumulated in the plurality of signal accumulators through the exposure and a transfer period in which the signals are transferred from the plurality of signal accumulators to obtain the imaging signal into a period for obtaining the distance image and a period for obtaining the luminance image, performs a temporally independent control, and makes at least one of the plurality of signal accumulators and a driving method for transferring the signals from the plurality of signal accumulators in the exposure period different between a signal for obtaining the distance image and a signal for obtaining the luminance signal.

7. The imaging device according to any one of claims 1 to 6,
   wherein the light which the light source unit emits is infrared light having a wavelength of from 750 nm to 4,000 nm, and the imager further includes an optical band-pass filter (BPF) which passes light having a wavelength close to a wavelength of the light emitted from the light source unit.

8. The imaging device according to any one of claims 1 to 7,
   wherein the solid-state imaging element generates, from the same pixel, a second imaging signal which is obtained when the irradiation light is not emitted, and
   the imaging device obtains the luminance image by subtracting the second imaging signal from the luminance imaging signal generated when the irradiation light is emitted.

9. The imaging device according to any one of claims 1 to 8,
   wherein the controller makes a duty ratio of the light emission signal for controlling light emission of the light source unit different between an exposure period for obtaining signals of the distance image and an exposure period for obtaining signals of the luminance image.

10. The imaging device according to any one of claims 1 to 9,
    wherein signals that are obtained through the exposure for different lengths of exposure time and are used for obtaining the luminance image are accumulated in different ones of the plurality of signal accumulators.

11. The imaging device according to any one of claims 1 to 10,
    wherein the signal processor uses, in the calculation for obtaining the distance image, at least one of the luminance imaging signal obtained when the light source unit emits the irradiation light and the second imaging signal obtained when the light source unit does not emit light.

12. The imaging device according to any one of claims 1 to 11,
    wherein the solid-state imaging element is a charge coupled device (CCD) solid-state imaging element.

13. The imaging device according to any one of claims 1 to 11,
wherein the solid-state imaging element is a complementary metal oxide semiconductor (CMOS) solid-state imaging element.

14. The imaging device according to claim 13,
wherein the solid-state imaging element includes, between adjacent ones of the plurality of signal accumulators that are located on a same side of a light-receiving region, a transfer controller which controls transfer of charges.

15. A solid-state imaging element used in an imaging device including:

a controller which generates a light emission signal and an exposure signal, the light emission signal instructing emission of irradiation light, the exposure signal instructing exposure to reflected light from an object;
a light source unit configured to emit the irradiation light according to the light emission signal;
an imager including a solid-state imaging element which includes a plurality of pixels, performs exposure a plurality of times according to the exposure signal, performs image capture in which signals are accumulated in different ones of a plurality of signal accumulators among the plurality of pixels, and outputs an imaging signal corresponding to the image capture; and
a signal processor which outputs a distance image and a luminance image according to calculation based on a signal amount of the imaging signal,
wherein the imaging signal includes a distance imaging signal for obtaining the distance image by calculation and a luminance imaging signal for obtaining the luminance image by calculation,
the solid-state imaging element generates the distance imaging signal and the luminance imaging signal from a same one of the plurality of pixels, and
the solid-state imaging element performs exposure for obtaining the luminance imaging signal using the reflected light of the irradiation light emitted according to a timing indicated by the light emission signal, as with exposure for obtaining the luminance imaging signal.

FIG. 1

SUBJECT

IRRADIATION LIGHT

REFLECTED LIGHT OR
BACKGROUND LIGHT

LIGHT EMISSION
SIGNAL

LIGHT
SOURCE
UNIT

SOLID·STATE IMAGING ELEMENT

20

CONTROLLER

IMAGER

3B

LIGHT EMISSION
SIGNAL
CONTROLLER

1

2

SECOND
IMAGING
SIGNAL

DISTANCE
IMAGING
SIGNAL

LUMINANCE
IMAGING
SIGNAL

3A

EXPOSURE
SIGNAL
CONTROLLER

EXPOSURE
SIGNAL

IMAGING
SIGNAL

3

SIGNAL
PROCESSOR

DISTANCE
IMAGE
(DISTANCE
SIGNAL)

LUMINANCE
IMAGE
(LUMINANCE
SIGNAL)

4

IMAGING DEVICE

10

FIG. 2A

FIG. 2B

| IR | IR | IR | IR |
| IR | IR | IR | IR |
| IR | IR | IR | IR |
| IR | IR | IR | IR |

27

FIG. 2C

REFLECTED LIGHT → → DISTANCE IMAGING SIGNAL

IR → LUMINANCE IMAGING SIGNAL

BACKGROUND LIGHT → → SECOND IMAGING SIGNAL

27

FIG. 2D

| W | W | W | W |
|---|---|---|---|
| IR | IR | IR | IR |
| W | W | W | W |
| IR | IR | IR | IR |

FIG. 2E

| R | G | R | G |
|---|---|---|---|
| IR | B | IR | B |
| R | G | R | G |
| IR | B | IR | B |

# FIG. 3

FIG. 4

EP 3 425 901 A1

FIG. 5

FIG. 6

(a)

FIRST SET

FIRST LIGHT EMISSION /EXPOSURE PERIOD | SECOND LIGHT EMISSION /EXPOSURE PERIOD | THIRD LIGHT EMISSION /EXPOSURE PERIOD

N-TH SET

FIRST LIGHT EMISSION /EXPOSURE PERIOD | SECOND LIGHT EMISSION /EXPOSURE PERIOD | THIRD LIGHT EMISSION /EXPOSURE PERIOD

TOF TRANSFER PERIOD

LIGHT EMISSION SIGNAL

EXPOSURE SIGNAL

READOUT SIGNAL { ΦV1 ΦV5 }

m TIMES

(b)

IRRADIATION LIGHT

DELAY Td DEPENDENT ON OPTICAL PATH

REFLECTED LIGHT

FIRST EXPOSURE SIGNAL (A0 EXPOSURE SIGNAL)

EXPOSURE AMOUNT

$T_0$

EXPOSURE AMOUNT
a0

EXPOSURE TO REFLECTED LIGHT

EXPOSURE TO BACKGROUND LIGHT

(c)

DELAY Td DEPENDENT ON OPTICAL PATH

SECOND EXPOSURE SIGNAL (A1 EXPOSURE SIGNAL)

EXPOSURE AMOUNT

$T_0$

EXPOSURE AMOUNT
a1

EXPOSURE TO REFLECTED LIGHT

EXPOSURE TO BACKGROUND LIGHT

(d)

NO LIGHT EMISSION

BACKGROUND EXPOSURE SIGNAL (BG EXPOSURE SIGNAL)

EXPOSURE AMOUNT
a2

EXPOSURE TO BACKGROUND LIGHT

FIG. 7

LUMINANCE TRANSFER PERIOD

YBG

YIR

TIME

T1 T3 T5 T7 T9
T2 T4 T6 T8
FORWARD TRANSFER

ΦV1
ΦV2
ΦV3
ΦV4
ΦV5
ΦV6
ΦV7
ΦV8
IRRADIATION LIGHT
REFLECTED LIGHT
ΦSUB

## FIG. 8

EP 3 425 901 A1

# FIG. 9

| | A2-1 | | A0-2 |

ΦV1
ΦV2
ΦV3
ΦV4

ΦV5
ΦV6
ΦV7
ΦV8

IRRADIATION LIGHT
REFLECTED LIGHT
ΦSUB

TIME

T20 T22 T24 T26 T28 T30 T32 T34 T36

T19 T21 T23 T25 T27 T29 T31 T33 T35

T1 T3 T5 T7 T9

T2 T4 T6 T8

BACKWARD BACKWARD
TRANSFER  TRANSFER

FORWARD
TRANSFER

EP 3 425 901 A1

32

FIG. 10

EP 3 425 901 A1

# FIG. 11

(a)

FIRST SET — N-TH SET

| FIRST LIGHT EMISSION /EXPOSURE PERIOD | SECOND LIGHT EMISSION /EXPOSURE PERIOD | THIRD LIGHT EMISSION /EXPOSURE PERIOD | FIRST LIGHT EMISSION /EXPOSURE PERIOD | SECOND LIGHT EMISSION /EXPOSURE PERIOD | THIRD LIGHT EMISSION /EXPOSURE PERIOD | TOF TRANSFER PERIOD |

LIGHT EMISSION SIGNAL

EXPOSURE SIGNAL

m TIMES    m TIMES    m TIMES    m TIMES    m TIMES    m TIMES

READOUT SIGNAL { $\Phi V1$  $\Phi V5$ }

WHEN $Td \geq T0$

$T_0$

IRRADIATION LIGHT

DELAY Td DEPENDENT ON OPTICAL PATH

REFLECTED LIGHT

FIRST EXPOSURE SIGNAL (A0 EXPOSURE SIGNAL)

SECOND EXPOSURE SIGNAL (A1 EXPOSURE SIGNAL)

THIRD EXPOSURE SIGNAL (A2 EXPOSURE SIGNAL)

EXPOSURE AMOUNT
a1
EXPOSURE TO REFLECTED LIGHT

EXPOSURE AMOUNT
a2
EXPOSURE TO REFLECTED LIGHT

EXPOSURE AMOUNT
a0

EXPOSURE AMOUNT

EXPOSURE TO BACKGROUND LIGHT
(b)

EXPOSURE TO BACKGROUND LIGHT
(c)

EXPOSURE TO BACKGROUND LIGHT
(d)

## FIG. 12

IRRADIATION
LIGHT

FIRST EXPOSURE
SIGNAL
(A0 EXPOSURE
SIGNAL)

SECOND EXPOSURE
SIGNAL
(A1 EXPOSURE
SIGNAL)

THIRD EXPOSURE
SIGNAL
(A2 EXPOSURE
SIGNAL)

$T_0$

$T_n$

$T_w$

$T_w$

$T_w$

## FIG. 13

NORMALIZED SIGNAL AMOUNT

ACTUAL DISTANCE

- - - FIRST EXPOSURE
SIGNAL PERIOD A0
—— SECOND EXPOSURE
SIGNAL PERIOD A1
—·— THIRD EXPOSURE
SIGNAL PERIOD A2

## FIG. 14

MEASURED DISTANCE VALUE

--- OVERLAP ABSENT
— OVERLAP PRESENT

ACTUAL DISTANCE

## FIG. 15

$T_0$

IRRADIATION LIGHT

REFLECTED LIGHT
Td

Dp

FIRST EXPOSURE SIGNAL
(A0 EXPOSURE SIGNAL)

SECOND EXPOSURE SIGNAL
(A1 EXPOSURE SIGNAL)

THIRD EXPOSURE SIGNAL
(A2 EXPOSURE SIGNAL)

A0 SIGNAL
EXPOSURE TO
REFLECTED LIGHT

A1 SIGNAL

A2 SIGNAL
EXPOSURE TO
BACKGROUND
LIGHT

FIG. 16

CONVERT INTO DISTANCE: $c \times T_0/2$

A1 SIGNAL

EXPOSURE AMOUNT

A0 SIGNAL

DETERMINED
PHASE VALUE

$Td - T_0$     $Dp = Td - T_0/2$     $Td$

RELATIVE PHASE BETWEEN LIGHT EMISSION SIGNAL
AND EXPOSURE SIGNAL (FIRST DELAY TIME)

# FIG. 17

# FIG. 18

EP 3 425 901 A1

# FIG. 19

EP 3 425 901 A1

# FIG. 20

FIG. 21

# FIG. 22

FORWARD TRANSFER

FORWARD TRANSFER

EP 3 425 901 A1

FIG. 23

FIG. 24

EP 3 425 901 A1

## INTERNATIONAL SEARCH REPORT

| International application No. |
|---|
| PCT/JP2017/006106 |

A. CLASSIFICATION OF SUBJECT MATTER
*H04N5/372*(2011.01)i, *G01B11/24*(2006.01)i, *G01C3/06*(2006.01)i, *G01S17/89* (2006.01)i, *H01L27/148*(2006.01)i, *H04N5/33*(2006.01)i

According to International Patent Classification (IPC) or to both national classification and IPC

B. FIELDS SEARCHED

Minimum documentation searched (classification system followed by classification symbols)
H04N5/372, G01B11/24, G01C3/06, G01S17/89, H01L27/148, H04N5/33

Documentation searched other than minimum documentation to the extent that such documents are included in the fields searched
Jitsuyo Shinan Koho          1922-1996   Jitsuyo Shinan Toroku Koho   1996-2017
Kokai Jitsuyo Shinan Koho    1971-2017   Toroku Jitsuyo Shinan Koho   1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | WO 2015/075926 A1 (Panasonic Intellectual Property Management Co., Ltd.),<br>28 May 2015 (28.05.2015),<br>paragraphs [0001] to [0225]<br>& US 2016/0259057 A1<br>paragraphs [0001] to [0259] | 1,2,4,5,7,8,<br>10-15<br>3,6,9 |
| Y | WO 2014/122714 A1 (Panasonic Intellectual Property Management Co., Ltd.),<br>14 August 2014 (14.08.2014),<br>paragraphs [0001] to [0101]<br>& US 2015/0341573 A1<br>paragraphs [0001] to [0134] | 1,2,4,5,7,8,<br>10-15 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 06 April 2017 (06.04.17) | 18 April 2017 (18.04.17) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

**INTERNATIONAL SEARCH REPORT**

| International application No. |
| --- |
| PCT/JP2017/006106 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | WO 2014/207788 A1 (Panasonic Intellectual Property Management Co., Ltd.), 31 December 2014 (31.12.2014), paragraphs [0001] to [0124] & US 2016/0103223 A1 paragraphs [0001] to [0154] | 13,14 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015194838 A